# FASCICULE DE BREVET EUROPEEN

(11) **EP 1 382 044 B1**
(45) Date de publication et mention de la délivrance du brevet: **28.09.2011**
(21) Numéro de dépôt: 02732836.8
(22) Date de dépôt: 24.04.2002
(51) Int. Cl.: G11C 27/02, G11C 27/04

(54) **ECHANTILLONNEUR ANALOGIQUE RAPIDE A GRANDE PROFONDEUR MEMOIRE**
SCHNELLE ANALOGE ABTAST- UND HALTESCHALTUNG MIT GROSSER SPEICHERTIEFE
FAST ANALOG SAMPLER WITH GREAT MEMORY DEPTH

(30) Priorité: 26.04.2001 FR 0105607
(43) Date de publication de la demande: 21.01.2004
(73) Titulaire: CENTRE NATIONAL DE LA RECHERCHE SCIENTIFIQUE (CNRS), 75794 Paris Cedex 16 (FR); Commissariat à l'Énergie Atomique et aux Énergies Alternatives, 75015 Paris (FR)
(72) Inventeur: BRETON, Dominique, F-33340 Queyrac (FR); DELAGNES, Eric, F-92370 Chaville (FR)
(74) Mandataire: Poulin, Gérard
(86) Numéro de dépôt international: PCT/FR2002/001409
(87) Numéro de publication internationale: WO 2002/089145

(56) Documents cités:
- EP-A- 0 350 027
- US-A- 4 037 119
- US-A- 5 526 301
- US-A- 5 963 063
- US-A- 6 097 232

## Description

### Domaine technique

L'invention se situe dans le domaine des échantillonneurs analogiques rapide et grande profondeur mémoire à fréquence d'échantillonnage variable.

### Etat de la technique.

Le brevet US 5,144,525 délivré le 1/9/1992 décrit un système d'acquisition d'un signal analogique comportant un ensemble matriciel de cellules de stockage d'un signal analogique circulant sur un bus analogique. Dans la description de l'art antérieur faîte dans ce brevet d'un ensemble matriciel analogue, il est expliqué qu'une cellule du réseau matriciel est sélectionnée pour l'écriture d'une valeur analogique, au moyen de deux registres à décalage. Un premier registre dans une première direction Y détermine la ligne de la cellule d'écriture. Un second registre dans une seconde direction X détermine la colonne de la cellule d'écriture. La cellule d'écriture se trouve ainsi au croisement de la ligne et de la colonne sélectionnée. Il est expliqué que la fréquence maximum d'échantillonnage de cet ensemble matriciel de l'art antérieur est déterminée par la fréquence maximum d'horloge de l'un des deux registres à décalage.

Le brevet US 5,144,525 propose pour augmenter la fréquence d'échantillonnage, par rapport à ce dispositif de l'art antérieur, un dispositif comportant comme déjà connu un ensemble matriciel 10 de cellules 16 de stockage d'un signal analogique. La sélection de la ligne R de la cellule d'écriture est toujours effectuée dans la direction Y par un premier registre à décalage 18. La sélection de la colonne C de la cellule d'écriture est, elle, effectuée au moyen d'une ligne à retard 22 munie de sorties successives.

Chacune des cellules 16 est munie d'un moyen de commande'd'écriture, par exemple sous forme d'une porte "et" 24 dont les deux entrées 32, 34 reçoivent l'une le signal en provenance du registre à décalage 18 commandant les lignes, et l'autre le signal en provenance de l'une des sorties de la ligne à retard 22. La sortie de la porte "et" commande la grille d'un transistor 26 à effet de champs. Lorsque le transistor à effet de champ est passant, le signal à échantillonner en provenance du bus analogique 12 est dirigé par l'intermédiaire du chemin drain - source du transistor, vers une capacité de stockage 30 connectée entre la masse et une sortie 28 permettant une lecture ultérieure.

Avec un tel dispositif la fréquence d'échantillonnage n'est plus limitée par la fréquence d'horloge d'un registre à décalage, mais par la durée du retard pour qu'un signal de commande se propage d'une sortie à l'autre de la ligne à retard commandant les colonnes. Il est indiqué en haut de la colonne 4 de ce brevet que la durée de propagation du signal de commande de la ligne à retard 22 peut être de l'ordre de 500 picosecondes, conduisant à des fréquences d'échantillonnage de l'ordre du gigahertz.

Un premier exemple de circuit de lecture est décrit colonne 10 lignes 10-24 en relation avec la figure 19 du brevet US 5 144 525. Chaque sortie 28 d'une cellule 16 débouche sur un tampon 94, ayant une entrée 96 d'autorisation de ligne. La tension sur la colonne de sortie 101 des tampons 94 d'une ligne est sélectionnée de façon séquentielle par un multiplexeur 102, qui délivre en série les sorties d'une ligne courante puis de la suivante, jusqu'à lecture complète de toutes les cellules 16 de l'ensemble matriciel.

Pour un bon fonctionnement d'un tel dispositif il est important que la commutation de sélection de ligne intervienne à l'instant où l'écriture d'une ligne courante se termine. Ainsi toutes les cellules d'une ligne courante ont été écrites et l'on peut passer à la ligne suivante. Une mauvaise synchronisation entre la fin de l'écriture d'une ligne courante et le passage à la ligne suivante, déclenché par le registre à décalage 18, conduit à avoir des recouvrements d'enregistrement entre fin de ligne courante et début de ligne suivante, si le passage à la ligne suivante intervient trop tôt, ou à des trous dans la séquence des échantillons si le passage à la ligne suivante intervient trop tard.

Dans les deux cas la lecture ultérieure du signal sera faussée, par une mauvaise appréciation de la durée écoulée entre échantillons successifs pour certaines successions d'échantillons, ou par manque d'échantillons.

Il convient de noter à ce stade que de telles erreurs dans l'enregistrement d'un signal, même à faible taux, entraînent des erreurs importantes sur une transformée de Fourier du signal enregistré.

Afin de régler le temps de transit dans la ligne à retard 22, pour qu'il soit exactement égal au temps de passage d'une sortie à la suivante, il est prévu dans ce document de l'art antérieur, un réglage du retard apporté par les différents tampons 62, constituant ensemble la ligne à retard 22. Ce réglage décrit colonne 8 à partir de la ligne 20, comporte un détecteur de coïncidence recevant sur une entrée A le signal de fin de ligne, sur une entrée B le signal d'horloge du registre à décalage 18. Un écart entre ces deux signaux se traduit par une tension d'écart qui est utilisée pour régler une tension de fonctionnement de chacun des tampons 62.

Malgré cette précaution, il n'est pas exclu que le défaut de synchronisation signalé plus haut se manifeste. On notera également qu'un tel dispositif génère de par son principe de fonctionnement un bruit propre important de nature à augmenter sérieusement la valeur du rapport signal sur bruit du signal enregistré. Ce bruit est dû essentiellement au fait que la commutation pour le passage d'une cellule d'enregistrement à la suivante se fait sur toute la colonne comportant cette cellule.

On notera pour faciliter la comparaison avec la description qui va suivre de l'invention qu'il revient au même que le registre à décalage soit installé parallèlement à la direction X perpendiculairement aux colonnes.

Le brevet US-A 5,526,301 décrit également un système d'acquisition de données composé de 100 cellules d'acquisition rangées selon 10 lignes et 10 colonnes. Les cellules d'enregistrement sont représentées sous la référence 52 figure 5, de ce brevet. La figure 2 de ce brevet montre les moyens de commande du début et de la fin de prise d'échantillon pour chacune des cellules 52.

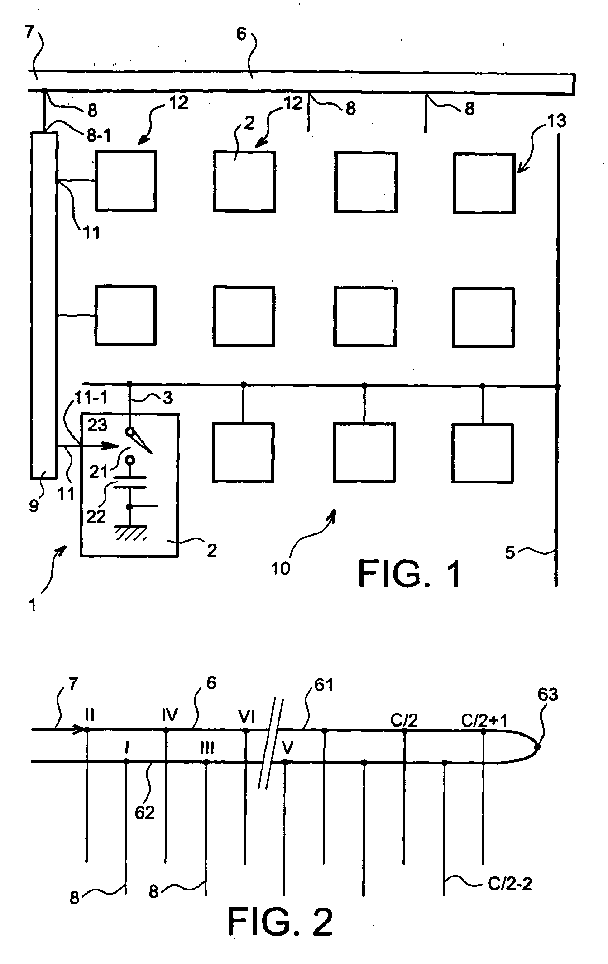

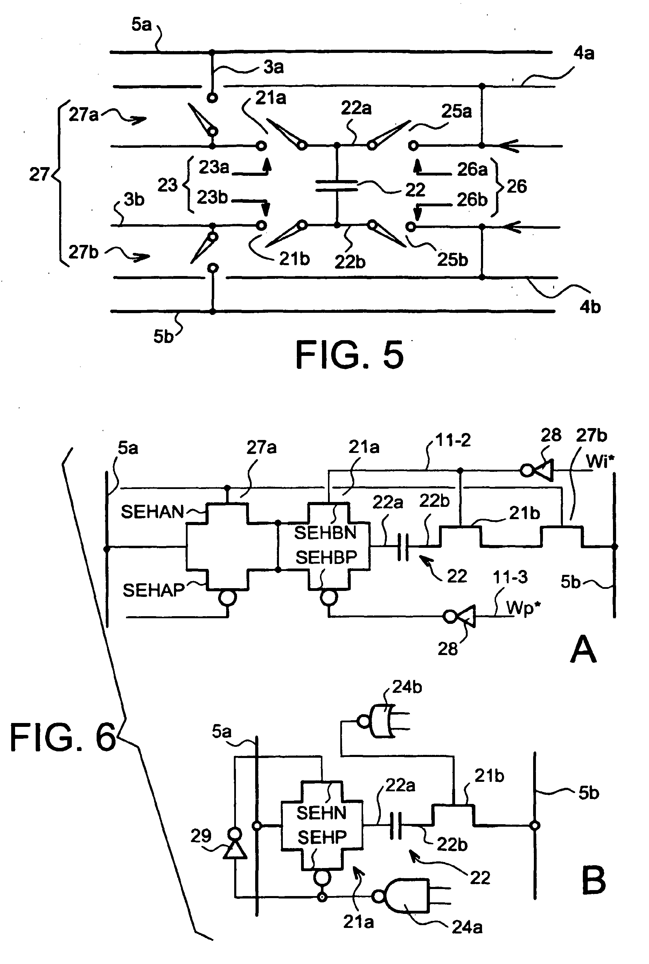

A l'examen de la figure 2 en liaison avec la description, on comprend que la fin de la prise d'échantillon de la cellule 52 située au croisement de la première ligne et de la première colonne est commandée par un signal X₀₀. Le signal X₀₀ est équivalent à un signal X₀ mais décalé dans le temps par un retard D₀₀. Le signal X₀ est un signal obtenu à la première sortie d'un registre à décalage 28. La propagation du signal X₀ au travers d'éléments de retard D₀₀ à D₀₉ commande ainsi successivement au travers de bascules 50 représentées figure 5, les fins successives de prise d'échantillon. Les prises d'échantillons des cellules 52 de la deuxième colonne sont aussi commandées par un signal X₁ qui a par rapport au signal X₀ un retard correspondant à une période d'horloge du registre à décalage 28. On continue ainsi jusqu'à la dixième colonne à laquelle correspond le signal X₉. Le début de prise d'échantillon est commandé par un signal X₆ ou X_{B} en provenance d'une onzième et d'une douzième sortie respectivement, du registre à décalage 28. La question de la synchronisation entre la fin de la prise d'échantillon dans une colonne et le début de la prise d'échantillon dans une colonne suivante n'est pas abordée dans ce brevet. On note également que du fait de la distribution commune à plusieurs colonnes, de façon simultanée, du signal de début de prise d'échantillon la durée de prise d'échantillon est variable pour les différentes cellules 52, ce qui contribue à distordre le signal échantillonné. De plus le nombre de cellules en cours de prise d'échantillons varie fortement au cours du temps, ce qui entraîne des variations permanentes de la bande passante du système au cours du temps. Ces variations contribuent également à la distorsion du signal échantillonné.

### Brève description de l'invention

Par rapport à l'état de la technique qui vient d'être décrit, dans l'un ou l'autre des deux documents cités, l'invention vise un dispositif d'enregistrement et de lecture présentant un rapport signal sur bruit amélioré, une plus grande régularité d'enregistrement, chacun des échantillons étant enregistré à l'instant et à l'endroit prévu.

Il s'agit d'un dispositif FISO (fast-in slow-out) de grande profondeur à fréquence d'échantillonnage variable pouvant atteindre ou dépasser le GHz. Dans un tel dispositif l'écriture est rapide de façon à échantillonner valablement des signaux large bande, et la lecture se fait à une échelle de temps agrandie. Le temps de lecture est donc nettement supérieur au temps d'écriture.

Comme dans l'art antérieur, le réseau matriciel de stockage est constituée par un ensemble de cellules rangées en ligne et colonnes. Un pointeur d'écriture de colonne constitué par un signal en sortie d'un registre à décalage détermine la colonne d'écriture.

Chaque colonne d'écriture d'un échantillonneur selon l'invention est munie d'une ligne à retard, ayant au moins autant d'éléments de retard qu'il y a de lignes dans le réseau matriciel.

La colonne d'écriture est déterminée par un signal présent en sortie d'un registre à décalage. La cellule d'écriture dans cette colonne est déterminée par une sortie d'un signal en provenance de la ligne à retard associée à cette colonne. Les signaux de début et de fin de prise d'échantillon proviennent tous deux de ladite ligne à retard. De la sorte, pour chaque prise d'échantillon, seule la cellule de la colonne d'écriture choisie par la ligne à retard peut être commutée. On veut dire par là qu'une prise d'échantillon n'est commencée par une cellule suivante qu'après le début de prise d'échantillon d'une cellule précédente. Il en est de même pour la fin de prise d'échantillon, qui n'intervient qu'après la fin de prise d'échantillon d'une cellule précédente. Cette première caractéristique permet de minimiser le bruit d'écriture, d'assurer des durées constantes et égales entre elles des prises d'échantillons de chacune des cellules, et garantit que le nombre de cellules en phase de prise d'échantillons est constant. De ce fait la bande passante du système est constante et la distorsion du signal échantillonné est fortement diminuée. Cette première caractéristique sera décrite plus en détail plus loin.

Selon une seconde caractéristique qui peut être combinée avec l'art antérieur décrit dans l'un ou l'autre des deux brevets cités ci-dessus, ou avec l'art antérieur modifié selon la première caractéristique, le réseau matriciel de cellules d'écriture et de lecture peut être replié. Une définition de ce qui est entendu par réseau matriciel replié et un mode de réalisation d'un tel réseau replié sera décrit plus loin.

Selon une troisième caractéristique qui peut se combiner avec l'art antérieur décrit dans l'un ou l'autre des deux brevets cités ci-dessus, ou avec l'art antérieur modifié selon la première caractéristique ou selon la seconde caractéristique ou encore qui peut se combiner avec l'art antérieur et les deux premières caractéristiques, un bus analogique portant le signal à enregistrer est divisé en autant de divisions que de lignes du réseau matriciel, et chacune des divisions porte un amplificateur suiveur recevant le signal à enregistrer et le mettant à un niveau suffisant pour être enregistré.

Selon une quatrième caractéristique qui peut être combinée seule avec l'art antérieur décrit dans l'un ou l'autre des deux brevets cités ci-dessus, ou avec l'une ou plusieurs des caractéristiques déjà citées, chaque cellule du réseau matriciel incorporée dans un échantillonneur selon l'invention, comporte au moins deux interrupteurs d'écriture. Le premier interrupteur d'écriture est connecté à une partie chaude du bus d'écriture, et le second interrupteur d'écriture est connecté à une partie froide ou retour de ce même bus d'écriture. Au moment de la connexion du bus d'écriture l'ordre d'actionnement des interrupteurs importe peu. Par contre, à l'instant de déconnexion de la cellule par rapport au bus d'écriture, selon une caractéristique importante, c'est l'interrupteur qui connecte la cellule à la partie froide ou retour du bus qui est actionné en premier. Pour que cette condition soit réalisée, il suffit qu'une commande de cet interrupteur reçoive un signal de déconnexion un court instant avant que le second interrupteur qui connecte ladite cellule à la partie chaude du signal d'écriture ne reçoive son propre signal d'interruption. La partie froide du bus d'écriture étant par exemple reliée à la masse, il n'y a pas d'influence de la valeur enregistrée sur la valeur d'échantillonnage.

Enfin selon une cinquième caractéristique, l'enregistreur est un enregistreur différentiel. Il comporte un premier bus ayant une entrée connectée à une première source délivrant le signal à enregistrer à une première polarité et un second bus ayant une entrée connectée à une seconde source délivrant le signal à enregistrer à une seconde polarité inverse de la première. Les deux bus sont divisés pour former des divisions. La matrice de cellules est organisée en paires de lignes consécutives. La première ligne d'une paire est connectée à une division du premier bus; la seconde ligne d'une paire est connectée à une division du second bus. Les lignes d'une paire étant consécutives, les instants d'échantillonnage de cellules de la paire de lignes appartenant à la même colonne, peuvent être quasiment simultanés.

Cette cinquième caractéristique, qui sera décrite plus loin, peut comme chacune des quatre autres être combinée à l'art antérieur décrit dans l'un ou l'autre des deux brevets cités ci-dessus, ou à l'art antérieur amélioré par une ou plusieurs des quatre autres caractéristiques.

Dans un échantillonneur la sélection d'une colonne détermine le choix d'une première cellule d'écriture par exemple la cellule se trouvant dans ladite colonne sélectionnée et dans la première ligne. L'écriture dans la première cellule de ladite colonne est rendue possible parce que un bus d'écriture portant le signal à enregistrer est connecté par un interrupteur contrôlé en ouverture et fermeture. Le contrôle de ce premier interrupteur est effectué à partir du signal en sortie du registre à décalage de sélection de colonne. Ce signal de contrôle est transmis par une ligne à retard à un interrupteur d'écriture de la ligne d'écriture suivante et ainsi de suite jusqu'à atteindre la dernière des lignes d'enregistrement du réseau matriciel. Ainsi chacune des colonnes du réseau matriciel de stockage est équipée d'une ligne à retard comportant autant de sorties que de lignes du réseau matriciel. Le signal de sortie d'une ligne à retard commande la sélection d'une seule cellule et ne provoque une commutation de début de capture ou de fin de capture d'échantillon que pour cette seule cellule. On évite ainsi qu'un bruit de commutation à haute fréquence de répétition et donc à large spectre soit diffusé dans tout le réseau matriciel et perturbe le signal à enregistrer. De plus, par le principe même de réalisation on est assuré que l'instant d'échantillonnage d'une cellule courante n'intervient qu'après l'instant d'échantillonnage d'une cellule précédente, puisqu'il y a unicité de la cellule qui peut être échantillonnée.

En résumé l'invention est relative à un échantillonneur analogique pour l'enregistrement de données analogiques relatives à un signal selon la revendication 1.

Enfin l'invention concerne également un procédé de capture d'échantillons analogiques selon la revendication de procédé 14.

### Brève description des dessins

D'autres caractéristiques et avantages de l'invention apparaîtront lors de la description d'exemples de réalisation et de variantes qui sera faîte ci-après en regard des dessins annexés dans lesquels :
- la figure 1 est un schéma représentant le mode le plus général de réalisation de l'invention selon sa première caractéristique ;
- la figure 2 est un schéma représentant un mode physique d'arrangement des colonnes d'un réseau matriciel dans lequel le réseau est replié ;
- la figure 3 est un premier exemple de réalisation de l'invention
- la figure 4 est un deuxième exemple de réalisation de l'invention montrant en particulier un mode de réalisation de la troisième caractéristique dans lequel le nombre de lignes est pair deux lignes consécutives enregistrant l'une une polarité du signal à enregistrer et l'autre la polarité inverse ;
- la figure 5 est un schéma représentant un exemple de réalisation d'une cellule d'enregistrement conforme au quatrième mode de réalisation de l'invention ;
- la figure 6 est un schéma représentant des exemples de réalisation de moyens de commutation présents dans une cellule pour valider ladite cellule et commuter ladite cellule sur le bus de données à enregistrer. Cette figure comporte une partie A représentant un premier exemple et une partie B représentant un second exemple ;
- la figure 7 comporte les parties A, B, C. La partie A est un schéma de représentation d'une ligne à retard. Les parties B, et C, représentent des formes de signaux ;
- la figure 8 est un schéma représentant un circuit de contrôle des retards d'une ligne à retard ;

De plus, il est annexé à la présente description un tableau représentant des valeurs d'un mot de validation des lignes.

### Description détaillée d'exemples de réalisation de l'invention

Sur la figure 1, il est représenté de façon schématique un dispositif 1 d'enregistrement selon l'invention. Ce dispositif comporte un réseau matriciel 10 de cellules 2 composé d'un nombre de préférence pair de L lignes référencées chacune 13 et de C colonnes référencées chacune 12. Le nombre de cellules 2 est ainsi égal à LxC. Chacune des cellules 2 a une entrée analogique 3 connectée à un bus analogique 5. Sur la figure 1 pour ne pas surcharger la figure, seule la connexion au bus 5 des cellules de la dernière ligne a été représentée. Un registre à décalage 6 dit d'écriture de colonne a une entrée 7 couplée à une source non représentée d'un signal d'horloge délivrant un signal à une fréquence dite principale Fp. Ce registre 6 à décalage a des sorties 8, successives. Chaque sortie 8 du registre d'écriture 6 est couplée à une entrée 8' d'une ligne à retard 9. La ligne à retard 9 a un nombre L ou 2L de sorties successives 11 au moins égal au nombre de lignes du réseau 10 matriciel de cellules 2. Sur la figure 1, pour ne pas surcharger la figure, une seule ligne à retard 9 a été représentée, mais il faut comprendre que des lignes 9 semblables sont associées à chaque colonne du réseau matriciel de cellules 2, en sorte qu'au total il y a au moins C lignes à retard 9. Il sera vu plus loin que dans l'un des modes de réalisation il peut y avoir une ligne à retard supplémentaire dédiée au contrôle du temps de parcours de l'ensemble des lignes à retard. Toutes les cellules 2 sont semblables. Du fait des simplifications apportées dans la représentation, seule la cellule 2 située dans le coin inférieur gauche du réseau matriciel de cellules 2 est représentée avec une entrée de commande numérique 11-1 connectée à la sortie 11 de la ligne à retard 9 et avec son entrée analogique 3 connectée au bus 5. Il faut cependant comprendre qu'il en va de même pour toutes les cellules 2. Afin de faire apparaître des détails de chaque cellule 2, la cellule 2 située dans le coin inférieur gauche du réseau matriciel de cellules 2 est représentée à une échelle agrandie par rapport aux autres cellules.

Chaque cellule 2 comporte des premiers moyens de commutation représentés sous forme d'un premier interrupteur commandable 21, et un condensateur de stockage 22 dont une borne est connectée à l'interrupteur 21. L'autre borne de l'interrupteur 21 est connectée au bus analogique 5. La commande 23 symbolisée par une flèche de l'interrupteur 21 est raccordée à l'entrée numérique 11-1 de la cellule 2.

Le fonctionnement est le suivant.

Un pointeur d'écriture de colonne de durée égale par exemple à 1/Fp, introduit par l'entrée 7 du registre 6 est propagé à la fréquence Fp dans ledit registre à décalage 6 de C sorties 8. Le signal en sortie de chacune des sorties 8 de ce registre est couplée à la ligne à retard 9 comprenant L retards, chacun de durée 1/(L x Fp). Le signal de sortie de chacun des retards constitue la commande 23 de l'interrupteur 21 d'écriture dans l'un des condensateurs 22 du réseau matriciel. Ainsi le signal issu d'un retard i de la colonne j, permettra d'enregistrer la valeur de l'échantillon du signal analogique dans la cellule mémoire 2 i, j, située à l'intersection de la ligne i et de la colonne j. i et j sont des nombres compris respectivement entre 1 et L et entre 1 et C.

Le dispositif 1 permet donc de réaliser un échantillonnage d'un signal analogique avec une période virtuelle de 1/(L x Fp), ce qui correspond à une fréquence d'échantillonnage maximum Féch = L x Fp. Si chacune des retards individuels entre sorties 11 consécutives de la ligne à retard 9 est par exemple de l'ordre de une nanoseconde, on peut ainsi obtenir avec un signal d'horloge Fp à 50 MHz des fréquences d'échantillonnage de l'ordre du GHz.

Selon une caractéristique optionnelle avantageuse de l'invention permettant de réduire la fréquence d'échantillonnage, des moyens permettent de valider ou d'inhiber les commandes d'écriture en sortie de tous les retards individuels d'une ligne. Si l'on inhibe de façon régulière, par exemple, une ligne sur deux, ou deux lignes sur 3, les fréquences d'échantillonnage correspondantes Fet seront divisées par deux ou par 3 respectivement. On peut ainsi diviser par un nombre petit m la fréquence d'échantillonnage. Pour des raisons qui seront expliquées plus loin dans la description il est préférable que le diviseur de fréquence d'échantillonnage m soit aussi un diviseur entier du nombre de lignes L. On aura donc intérêt à choisir un nombre L ayant un grand nombre de diviseurs entiers, par exemple L = 20, qui admet pour diviseur entier les nombres 1, 2, 4, 5 et 10.

Le mode de réalisation qui a été décrit ci-dessus, en liaison avec la figure 1, présente les avantages ci-après :
- il n'existe dans le circuit aucun signal de fréquence supérieure à Fp même lorsque la fréquence d'échantillonnage est supérieure à Fp.

Cette caractéristique permet :
- de limiter les perturbations des signaux analogiques par les commandes numériques,
- de diminuer la puissance dissipée,

Selon un mode de réalisation, schématisé figure 2, destiné à éviter les discontinuités dues aux effets de bord, en particulier celles liées aux temps de propagation, le réseau 10 matriciel de cellules 2 d'enregistrement est replié sur lui-même. Le registre à décalage (6) comporte un coude 63 à 180° formant ainsi une partie 61 aller située avant le coude et une partie 62 retour située après le coude. Des colonnes 12 et leurs lignes à retard 9 associées couplées à des sorties 8 du registre à décalage 6 d'écriture situées sur la partie 62 retour sont intercalées entre des colonnes 12 et leurs lignes à retard 9 associées couplées à des sorties 8 du registre à décalage (6) d'écriture situées sur la partie 61 aller.

Le pointeur d'écriture ira tout d'abord dans la première partie 61 du registre 6 d'écriture de colonne, de gauche à droite jusqu'au coude 63 à 180°. Les sorties 8 de cette première partie 61 sont couplées à une première partie des colonnes 12, par exemple aux colonnes 12 physiquement de rang pair. A l'arrivée, dans cet exemple, sur la colonne de numéro C/2 du registre, correspondant physiquement à l'avant dernière colonne du réseau matriciel, le pointeur passera à la dernière colonne 12 physiquement de rang impair. Le pointeur d'écriture rebroussera chemin en revenant vers la gauche sur toutes les colonnes physiquement de rang impair. Sur la figure 2 le registre à décalage 6 a été schématisé par une ligne horizontale allant de la gauche vers la droite puis de la droite vers la gauche. Chacune des colonnes 12 composée d'une ligne à retard 9 et de L cellules 2 a été symbolisée par un trait vertical ayant un rang pair ou impair. Les premières colonnes physiquement de rang pair 2, 4, 6 ... C/2 et la colonne physiquement de rang impair (C/2 + 1) sont sur le trajet 61 du registre à décalage 6 allant de la gauche vers la droite. Les dernières colonnes 12 physiquement de rang impair (C/2 - 1), (C/2 - 3) ...3, 1 sont sur le trajet 62 du registre à décalage 6 allant de droite à gauche. Sur la figure 2 les rangs des colonnes sont indiqués en chiffres romains pour les distinguer des autres signes de référence indiqués en chiffres arabes. Chaque colonne 12 physiquement de rang impair à l'exception éventuellement d'une première ou d'une dernière se trouve ainsi entre deux colonnes de rang pair. Le sens de parcours des colonnes 12 pour l'enregistrement va avec cette disposition physique des colonnes dans le sens des rangs pairs croissants puis des rangs impairs décroissants.

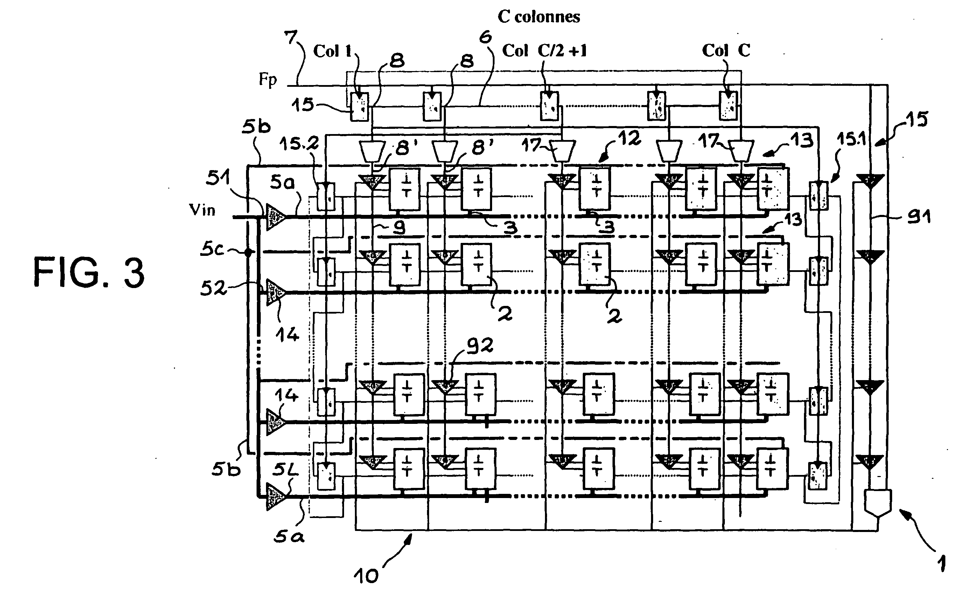

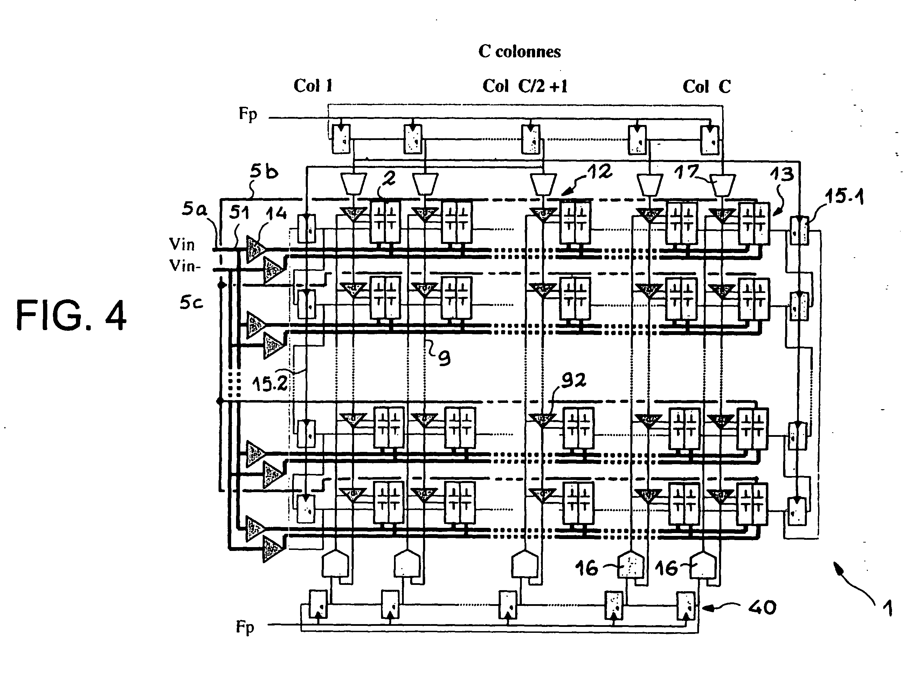

Quelques particularités du réseau matriciel 10 seront maintenant décrites en regard des figures 3 et 4 qui représentent chacune un réseau matriciel 10 replié, comme il vient d'être décrit ci-dessus, mais dans la représentation des figures 3 et 4, le réseau 10 est représenté déplié afin de ne pas surcharger les figures.

Dans les modes représentés sur les figures 3 et 4 le bus analogique d'entrée 5 est divisé en autant de divisions 51 52 ... 5L que de lignes 13 du réseau matriciel 10. Le bus 5 et ses divisions comportent un bus d'écriture 5a et un bus d'écriture retour 5b constituant une tension de référence. Les bus de retour 5b du signal d'écriture sont directement raccordés ensemble à une entrée 5c de référence du signal d'entrée.

Dans l'exemple représenté sur les figures 3 et 4, chacune des divisions 51 52 ... 5L du bus analogique comporte un amplificateur suiveur 14 appelé amplificateur d'écriture dont l'entrée reçoit le signal analogique à échantillonner et dont la sortie se trouve en amont de chacune des divisions en sorte que les cellules 2 reçoivent le signal amplifié en sortie d'un amplificateur suiveur 14. Ainsi Le signal analogique est tamponné dès son entrée dans le circuit par L, ou 2L dans le cas de la figure 4, amplificateurs suiveurs large bande qui attaquent chacun une division du bus d'écriture haut connectée à C cellules 2 mémoires. Ces amplificateurs 14 présentent un excellent appairage en terme de bande passante et de temps de montée du signal.

Ce mode de réalisation présente les avantages suivants :
- permettre une éventuelle décharge et recharge de la capacité 22 de chaque cellule au travers de l'amplificateur 14 pendant un temps de connexion de la cellule au bus 5 au travers de l'interrupteur 21, ce temps de connexion peut par exemple être aussi grand que 1/Fp.
- chacune des L divisions du bus analogique 5 est échantillonné au maximum à une fréquence Fp,
- les contraintes sur les amplificateurs tampons traitant l'entrée analogique au niveau de chaque division peuvent être relâchées,
- la durée des perturbations dues aux échantillonnages sur les bus d'écriture peut être quasiment aussi longue que la période d'une horloge étalon délivrant le signal à la fréquence Fp,
- cela permet d'obtenir un grand rapport signal sur bruit, peu de distorsion du signal enregistré, et une grande dynamique.

De façon à ce que le temps de parcours du signal de commande d'écriture le long d'une ligne à retard 9 associée à une colonne 12 soit égal au temps de transit du signal d'écriture de colonne d'une sortie 8 du registre à décalage d'écriture 6, à la sortie immédiatement suivante, les lignes à retard 9 sont asservies en durée. Les moyens d'asservissement du retard peuvent être présents pour chacune des C colonnes du réseau 10, comme représenté figure 4. A cette fin chacune des lignes 9 comporte un ensemble 16 comparateur de phase et pompe de charge permettant de régler une tension de polarisation de retards élémentaires constituant ensemble une ligne à retard 9.

Les moyens d'asservissement du retard peuvent aussi être présents pour une seule des C colonnes du réseau. Dans le cas où l'asservissement est réalisé sur une seule colonne servant de colonne de référence, il est préférable, comme représenté figure 3, de disposer d'une ligne 91 à retard supplémentaire.

Ce mode de réalisation avec une seule ligne à retard qui sert à l'asservissement de chacune des autres lignes à retard est plus adapté aux réseaux matriciels dans lesquels le nombre de cellules est faible, en particulier le nombre de cellules par colonne, et dans lesquels la fréquence d'échantillonnage est basse.

La structure plus détaillée et le fonctionnement des moyens de réglage du temps de parcours des ligne à retard 9 seront expliqués plus loin.

Il a été vu plus haut que la fréquence d'échantillonnage peut être réglée dans une certaine mesure par le masquage de lignes ou partie de lignes 13 du réseau matriciel 10. Pour réaliser cette fonction de masquage chaque cellule 2 est munie d'au moins une entrée numérique 11-2 de validation recevant d'un registre de validation 15 représenté sur chacune des figures 3 et 4, une commande de validation. Dans l'exemple représenté sur les figures 3 et 4 il y a en fait deux registres de validation 15-1 et 15-2 permettant une validation en deux fois des cellules 2 d'une ligne. Les registres de validation sont connectés à un générateur de mots de validation non représenté. La structure et le fonctionnement d'un registre de validation 15 en liaison avec les cellules 2 d'une ligne seront expliqués plus loin, ainsi que l'intérêt d'avoir deux registres 15-1 et 15-2 pour effectuer la validation en deux fois.

Dans le mode de réalisation préféré représenté figure 4 le signal à enregistrer est traité en amont du dispositif objet de l'invention et de façon en elle-même connue, de façon à obtenir un signal bipolaire. Chacune des polarités Vin+ et Vin- du signal est enregistrée séparément en sorte qu'un enregistrement de LxC échantillons de chaque polarité nécessite un nombre de lignes égal à 2L.

De façon optionnelle comme représenté figure 4, le registre à décalage d'écriture peut être dédoublé en un registre d'écriture 6 et un registre de référence 40. Les deux registres 6, 40 sont identiques et reçoivent le même signal d'horloge. Le registre de référence 40 est utilisé lors de l'écriture pour le contrôle de la durée de parcours des lignes à retard 9

La structure et le fonctionnement des éléments constituant ensemble le réseau matriciel 10 seront maintenant expliqués.

La structure et le fonctionnement d'une cellule mémoire 2 sera maintenant expliqué en référence aux figures 5 à 7.

En référence à la figure 5, chaque cellule 2 comporte le condensateur 22 de stockage d'une tension représentative de la grandeur analogique d'entrée. Le condensateur 22 a deux bornes 22a et 22b. Les premiers moyens de commutation 21 sont constitués en deux parties par deux interrupteurs, 21a et 21b. La borne 22a est couplée par l'intermédiaire de la première partie 21a des premiers moyens de commutation 21 d'écriture à la partie haute 5a du bus analogique 5. La partie de la première partie 21a des premiers moyens de commutation 21 raccordée en permanence au bus 5a constitue une première entrée analogique 3a de la cellule 2. La borne 22a est également couplée par l'intermédiaire d'un premier interrupteur de lecture 25a à la partie haute 4a d'un bus analogique de lecture 4. La borne 22b est couplée par l'intermédiaire de la seconde partie 21b des premiers moyens de commutation d'écriture 21 à la partie basse 5b du bus analogique 5. La partie de l'interrupteur 21b raccordée en permanence au bus 5b constitue une seconde entrée analogique 3b de la cellule 2. La borne 22b est également couplée par l'intermédiaire d'un second interrupteur de lecture 25b à la partie basse 4b du bus analogique de lecture 4. Les interrupteurs 21a, 21b, et 25a, 25b constituent ensemble respectivement les moyens 21 de commutation d'écriture et 25 de commutation de lecture. Chacun des moyens de commutation 21, 25 est commandé en ouverture et fermeture par des moyens de commande 23, 26 respectivement. Les moyens de commande 23, 26, sont composés de moyens de commande 23a, 23b, et 26a, 26b respectivement encore symbolisés à ce stade par des flèches 23a, 23b et 26a, 26b. Les moyens de commande 23a, 23b, et 26a, 26b commandent respectivement les interrupteurs 21a, 21b, et 25a, 25b.

Il a été vu plus haut que chaque ligne peut ou non être validée en écriture en fonction de la fréquence d'échantillonnage souhaitée. Dans un premier mode de réalisation la liaison entre le bus 5 et les bornes du condensateur 22 comporte de seconds moyens 27 de commutation composés d'interrupteurs 27a, 27b placés en série respectivement avec les interrupteurs 21a et 21b. Dans ce premier mode de réalisation, il importe peu que les moyens de commutation 21, par exemple, soient ouverts ou fermés, le signal n'arrivera pas à la capacité 22 si les moyens de commutation 27 ne sont pas également fermés. Dans un second mode de réalisation la validation ou l'inhibition d'une ligne se traduit par le fait que les moyens de commande de commutation ne peuvent fermer les moyens de commutation 21 que si la ligne est validée. Dans ce second mode de réalisation, la validation est assurée par un circuit logique connecté pour recevoir la commande de validation et la commande d'écriture et ne délivrant un signal de fermeture aux moyens de commutation 21 que lorsque les deux commandes, de validation et d'écriture sont présentes.

Deux exemples de réalisation des moyens de commutation d'écriture, de leurs commande et de validation au niveau de chaque cellule 2 seront maintenant exposés en liaison avec la figure 6. Un premier exemple correspondant au cas où des moyens de commutation 27 sont en série avec les moyens de commutation 21 fait l'objet de la figure 6 partie A. un deuxième exemple fait l'objet de la figure 6 partie B.

Les moyens de commutation d'écriture comprennent :
- l'interrupteur 21a d'écriture haut à base de transistor CMOS, comportant connectés en parallèle par leur chemin drain source un transistor PMOS et un transistor NMOS.
- l'interrupteur 21b d'écriture bas à base de transistor NMOS.

Dans le premier mode de réalisation représenté en partie A de la figure 6, deux interrupteurs CMOS un premier 21a faisant partie des premiers moyens de commutation et un second 27a faisant partie des seconds moyens de commutation sont placés en série entre le bus 5a d'écriture haut et la borne 22a du condensateur 22.

Le second interrupteur CMOS 27a, est composé d'un transistor NMOS **SEHAN,** commandé par un signal de validation enw (enable writing) appliqué à la grille dudit transistor **SEHAN,** et d'un transistor PMOS **SEHAP,** commandé par un signal de validation enw* de polarité opposée au signal enw appliqué à la grille dudit transistor **SEHAP.** Les transistors **SEHAN** et **SEHAP** sont mis en parallèle.

L'interrupteur CMOS 21a est composé d'un transistor **NMOS , SEHBN,** commandé par un signal d'écriture wi obtenu par inversion d'un signal wi* au travers d'un premier inverseur de polarité 28, appliqué à la grille dudit transistor **SEHBN,** et d'un transistor PMOS **SEHBP,** commandé par un signal wp* obtenu par inversion de polarité d'un signal wp au moyen d'un second inverseur de polarité 28, appliqué à la grille dudit transistor **SEHAP.** Les transistors **SEHBN** et **SEHBP** sont mis en parallèle.

Chacun des interrupteurs 21b, 27b est constitué par un transistor NMOS. Le second interrupteur 21b des premiers moyens de commutation 21 est commandé par un signal d'écriture wi appliqué à sa grille. Le second interrupteur 27b des seconds moyens de commutation 27, est commandé par le signal de validation enw. Les deux interrupteurs 21b et 27b sont placés en série entre le bus bas 5b et la seconde borne 22b du condensateur 22.

Dans le second mode de réalisation des moyens de commande de commutation et de commande de validation représenté figure 6 partie B, l'interrupteur 21a est constitué comme dans le cas décrit en relation avec la figure 6 partie A. L'interrupteur 21a comporte deux transistors en parallèle un transistor Nmos SEHN et un transistor Pmos SEHP connectés en parallèle entre le bus haut' 5'a et la première borne 22a de la capacité 22. L'interrupteur 21b est constitué par un transistor connecté entre la seconde borne 22b du condensateur 22 et le bus bas 5b. La grille du transistor SEHN reçoit au travers d'un inverseur de polarité 29 la sortie d'une porte "et" inverseuse 24a qui reçoit sur une première entrée un signal wp et sur une seconde entrée un signal de validation enw. La grille du transistor SEHP reçoit directement la sortie de la porte "et" inverseuse 24a. La grille du transistor 21b constituant l'interrupteur 21b reçoit le signal en provenance d'une porte "et" inverseuse 24b dont une entrée reçoit un signal enw* qui est l'opposé du.signal enw et l'autre entrée un signal wi*, formé à partir d'un signal wi d'écriture.

Les signaux wi Wi*, Wp, Wp* sont des signaux d'écriture qui proviennent de la ligne à retard 9 éventuellement au travers de dispositifs d'inversion de polarité. Les signaux enw, enw* sont des signaux de validation en provenance de registres de validation dont il sera parlé plus loin. Tous les signaux qui viennent d'être mentionnés sont des signaux logiques appliqués à des entrées numériques d'une cellule 2.

Dans l'exemple représenté figure 6 partie A, les entrées numériques d'écriture d'une cellule 2 sont constituées par les commandes appliquées sur les grilles des deux transistors constituant ensemble l'interrupteur 21a et du transistor 21b, soit au total trois entrées numériques d'écriture. Les entrées de validation d'écriture sont constituées par les commandes appliquées sur les grilles constituant ensemble l'interrupteur 27a, et la grille du transistor constituant l'interrupteur 27b, soit au total trois entrées numériques de validation.

Dans l'exemple représenté figure 6 partie B, les entrées numériques d'écriture d'une cellule 2 sont constituées par les commandes appliquées à une entrée de la porte 24a et une entrée de la porte 24b soit au total deux entrées numérique d'écriture. Les entrées de validation sont constituées par les commandes appliquées à l'autre entrée de chacune des portes 24a et 24b.

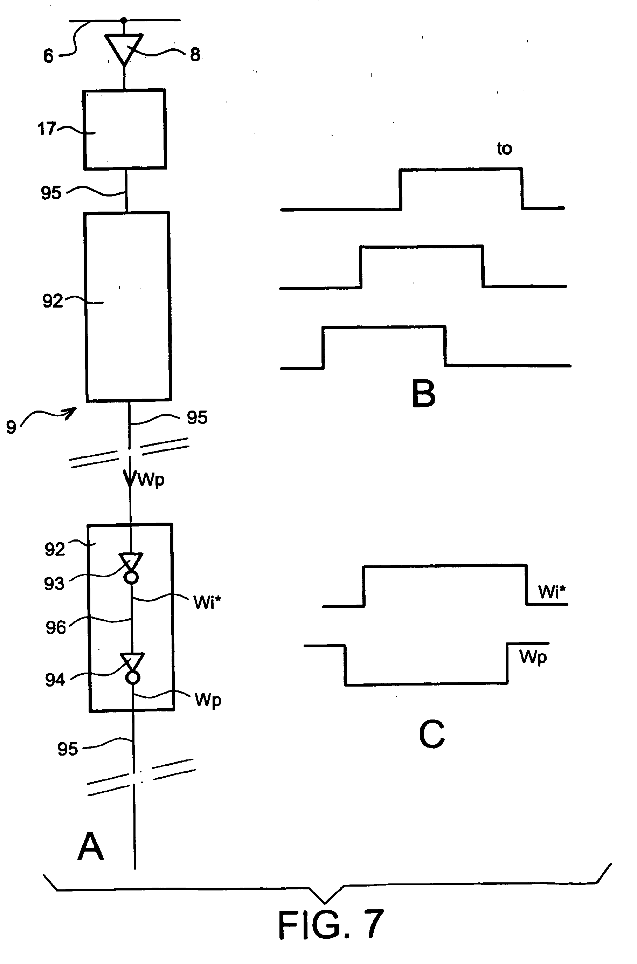

Le fonctionnement à ce stade en écriture seulement, sera maintenant commenté en liaison avec la figure 7. Dans ce qui suit on suppose que la ligne à laquelle appartient la cellule est validée et donc que l'écriture ne dépend que de la position des interrupteurs 21a et 21b.

Les éléments nécessaires à la compréhension de la chronologie d'écriture sont repris figure 7 partie A.

Le système de génération de commande d'écriture est composé, dans cet exemple :
- du registre 6 à décalage d'écriture comprenant C sorties 8 correspondant à chacune des colonnes 12,
- de C blocs de mise en forme référencés 17 sur les figures 3 et 4,
- de C lignes à retard digitales 9 comprenant chacune un nombre de sorties au moins égal au nombre de lignes soit au moins L sorties figure 3 et 2L sortie figure 4.

L'une seulement de ces lignes 9 est représentée en figure 7 partie A. La ligne se compose de L ou 2L retards élémentaires 92. Dans un mode avantageux de réalisation chacun des retards élémentaires 92 est constitué de deux demi retards élémentaires 93, 94 disposés en série. Un tel mode de réalisation est représenté pour l'un seulement des retards 92 figure 7 partie A.

Dans l'exemple représenté figure 7, partie A où chaque retard 92 se compose de deux demi-retards 93, 94, le nombre de sorties de la ligne à retard est un multiple, par exemple, dans le cas représenté égal à deux du nombre de retards élémentaires 92. Dans l'exemple particulier de réalisation, chacun des demi-retards est constitué par un inverseur. Ainsi, un signal wp présent en entrée d'un retard 92 aura pour transformée après passage dans le demi-retard 93 un signal wi* et après passage dans le demi-retard 94 de nouveau un signal wp. Les signaux wi et wp sont des signaux logiques. Le registre à décalage 6, d'écriture des colonnes est cadencé par l'horloge principale à la fréquence principale d'horloge Fp. Lors d'une initialisation du circuit 1, sa première cellule est fixée à 1 (PRESET), toutes les autres sont fixées à 0 (RESET). Une unique impulsion, appelée pointeur de colonne, de durée 1/Fp se propage donc le long du registre à raison d'une sortie par période 1/Fp.

Après (C-1) coups d'horloge, l'impulsion arrive à la dernière cellule du registre 6. Le coup d'horloge suivant, une nouvelle impulsion devra être générée dans la première cellule du registre. Pour cela deux solutions sont envisageables :
- soit en bouclant la sortie du registre sur l'entrée,
- soit en effectuant une nouvelle réinitialisation du registre lorsqu'un compteur, déclenché lors de la précédente initialisation aura compté C coups d'horloge.

Les moyens et leur connexion pour réaliser ces fonctions sont en eux-mêmes connus et n'ont pas été représentés car ils sont marginaux par rapport à l'invention.

Chacune des impulsions issues des C cellules du registre sera ensuite mise en forme et notamment mise à la durée souhaitée pour la durée de la période de capture, t0 pendant laquelle la capacité 22 est connectée à la fois au bus haut 5a et au bus bas 5b. Cette mise en forme est réalisée dans chaque bloc 17 de mise en forme, par exemple, en effectuant un ET ou un OU logique du signal sortant du registre 6 avec ce même signal dont le front montant ou descendant est retardé pour arriver à la durée souhaitée.

A la sortie de chacun des blocs 17 de mise en forme, le signal est envoyé dans la ligne à retard 9 composé de L retards élémentaires 92 dans les exemples représentés figure 3 et 4 respectivement.

Ce sont les signaux en provenance de chacun des retards élémentaires 92 constituant ensemble la ligne 9 qui constituent les commandes de fermeture et d'ouverture des interrupteurs 21 et 27.

Les signaux issus d'un bloc de mise en forme 17 ont la forme représentée en figure 7 partie B. Il s'agit de signaux carrés ayant une durée t0. Le signal est constitué par un front avant suivi d'une partie constante constituant un état logique haut, puis d'un front arrière ramenant à un état logique bas. A chaque sortie 95 d'un retard élémentaire 92 de la ligne à retard 9 le signal a la même forme et la même durée mais les fronts avant et arrière des sorties 95 consécutives sont décalés l'un par rapport à l'autre de la durée d'un retard élémentaire 92 en sorte que de la première à la dernière ligne les fronts de ces signaux sont de plus en plus décalés par rapport au front arrière du signal parcourant le registre à décalage 6. Trois de ces signaux présents à des sorties 95 consécutives sont représentés figure 7 partie B. Dans le mode de réalisation le plus simple on peut imaginer que chacun des interrupteurs 21a et 21b est constitué par un transistor dont l'état passant est commandé par l'état logique haut du signal présent à chaque sortie 95.

Un tel mode de réalisation a l'avantage de la simplicité mais il présente des inconvénients qui deviendront apparents lors de la description qui va suivre d'un mode préféré de réalisation.

Dans ce mode préféré chaque retard élémentaire 92 est constitué de deux demi retards élémentaires 93 et 94 disposés en série. De façon avantageuse chacun des retards est constitué par un inverseur. De la sorte le signal présent à une sortie intermédiaire 96 située entre les deux demi retard 92 et 94 a la forme et la durée des signaux représentés en partie B de la figure 7, mais les signaux présents aux sorties intermédiaires 96 entre deux demi-retards 92, 94 constituant ensemble un retard élémentaire, ont une polarité inversée. Ces signaux sont décalés par rapport au front arrière du signal en provenance du registre à décalage 6 d'un nombre impair de demi retards et non plus d'un nombre entier de retards. Le signal présent en sortie 95 est lui décalé d'un demi retard par rapport au premier mais de plus de polarité inversée. Un tel ensemble de deux signaux est représenté figure 7 partie C. Le signal présent en sortie 96 est appelé wi*, Le signal présent en sortie 95 est appelé wp.

La chronologie d'écriture d'un échantillon avec les interrupteurs 21a et 21b tels que représentés figure 6 partie A sera maintenant expliquée.

La sortie 96 est connectée au travers d'un inverseur 28 à l'entrée de grille du transistors NMOS constituant une partie de l'interrupteur 21a et à la grille du transistor 21b respectivement. Lorsque le signal wi passe à l'état logique haut ces deux transistors sont rendus passant en sorte que la capacité 22 est connectée entre les bus 5a et 5b. L'instant de fermeture intervient après le front arrière du signal issu du registre 6 à décalage à un instant dont le retard par rapport à ce front arrière est une fonction du nombre de retards élémentaires entre le registre 6 à décalage d'écriture de colonne et la cellule 2. Ce nombre de retards correspond à un demi retard près au numéro de la ligne. Les interrupteurs 21a et 21b sont fermés simultanément et restent fermés simultanément pendant la durée t0 correspondant à la durée du signal wi. Pendant cette durée t0 la tension aux bornes du condensateur 22 suit alors la différence de tension entre les deux bus d'écriture 5a et 5b. Il s'agit d'une phase de capture pendant laquelle la tension aux bornes de la capacité 22 s'établit et suit les fluctuations du signal à enregistrer. On note en relation avec la figure 6 partie A qu'il suffit que l'un des transistors constituant l'interrupteur 21a, par exemple le transistor NMOS, soit passant pour que l'interrupteur 21a soit fermé. Le second transistor - transistor PMOS- constituant l'interrupteur 21a va être commandé passant lorsque le signal wp va passer à l'état logique inverse haut. Cela signifie que ce transistor va devenir passant un demi retard élémentaire après que le transistor NMOS constituant une partie de l'interrupteur 21a aura lui-même été rendu passant. De même ce transistor deviendra non passant un demi retard élémentaire après que le transistor NMOS constituant une partie de l'interrupteur 21a aura lui-même été rendu non passant. Ce transistor sera donc encore passant à l'instant d'ouverture des transistors NMOS constituant une partie de l'interrupteur 21a et l'interrupteur 21b respectivement. Cela signifie que l'interrupteur 21b est ouvert avant l'interrupteur 21a. C'est donc l'interrupteur 21b qui commande l'instant d'échantillonnage du signal présent sur le bus 5, puisque la charge de la capacité 22 cesse dès que l'une de ses bornes est déconnectée. La tension aux bornes du condensateur 22 de stockage mémorise alors la différence de tension des deux bus d'écriture.

L'échantillonnage réel étant uniquement effectué par l'interrupteur 21b raccordé au bus 5b dont la tension est constante, l'instant d'échantillonnage ainsi que la charge injectée par les interrupteurs sont indépendants de l'amplitude du signal analogique mémorisé.

Un autre avantage de ce mode de réalisation vient de la mise en parallèle d'un transistor NMOS et d'un transistor PMOS pour réaliser l'interrupteur 21a. Du fait de ce montage l'impédance de l'interrupteur 21a est indépendante dans une large mesure de la valeur du signal à enregistrer, ce qui se traduit par une moindre distorsion de l'enregistrement.

Ainsi selon le mode de réalisation qui vient d'être décrit le second interrupteur 21b de chaque cellule 2 a son entrée de commande connectée à un retard élémentaire 92 ou demi retard élémentaire 93 de la ligne à retard 9 qui est situé en amont d'une sortie d'un retard élémentaire ou demi retard élémentaire auquel est connectée une entrée de commande du premier interrupteur 21a.

La chronologie de fonctionnement des interrupteurs dans le second mode de réalisation représenté figure 6 partie B est basée sur le même principe : l'interrupteur 21b se ferme et s'ouvre un demi retard avant l'interrupteur 21a dont les deux composants NMOS et PMOS sont actionnés simultanément.

Toutefois le montage selon ce second mode de réalisation est préféré en particulier en conjonction avec le mode différentiel d'enregistrement représenté figure 4 pour des facilités d'implantation dans le silicium. On note que dans ce mode différentiel de réalisation, les lignes de rang impair correspondent à un signal de première polarité et les lignes de rang pair à un signal d'une seconde polarité inverse de la première.

Deux solutions pour échantillonner le signal sont alors possibles, selon une première solution les lignes de rang pair et impair d'une paire sont connectées du point du vue des commandes d'écriture à une même sortie de la ligne à retard. Selon une seconde solution les lignes de rang pair d'une paire sont échantillonnés un demi retard après les lignes de rang impair de cette paire. Pour cela il suffit de connecter les entrées numériques de commande de prise d'échantillon des lignes paires à une sortie d'un demi retard 93 ou 94 de la ligne à retard 9 situé immédiatement en aval de la sortie du demi retard connecté à l'entrée numérique de commande de prise d'échantillon de la ligne de rang impair.

De façon en elle-même connue des inverseurs de polarité pour inverser les signaux de commande de prise d'échantillons pour commander les transistors PMOS ou NMOS selon la chronologie indiquée plus haut pourront être nécessaires.

Ainsi à la lecture du mode de fonctionnement décrit ci-dessus on voit que le procédé mis en oeuvre est un procédé de capture d'échantillons analogiques d'un signal analogique présent sur un bus analogique, dans des cellules 2 formant ensemble un réseau 10 matriciel de cellules ayant C colonnes 12 et L lignes 13 ou paires de lignes, C et L désignant des nombres entiers, dans lequel
- un signal de début de capture d'échantillon pour une cellule est reçu sur une première entrée numérique de ladite cellule
- et dans lequel un signal de fin de capture d'échantillon est reçu sur une seconde entrée numérique de ladite cellule
caractérisé en ce que on crée comme décrit ci-dessus par exemple dans les blocs de mise en forme 17, une impulsion ayant un front montant et un front descendant et en ce que
- les signaux de début et de fin de prise d'échantillon sont constitués par les fronts montant ou descendant de ladite impulsion, ces fronts étant reçus successivement sur une entrée numérique physiquement unique constituant successivement la première entrée numérique de commande de début et la seconde entrée numérique de commande de fin de capture d'échantillon.

La durée de prise d'échantillon est ainsi déterminée par la durée de l'impulsion comportant les fronts montant et descendant constituant les signaux de commande de début et de fin de prise d'échantillon. Du fait que cette impulsion est propagée d'une cellule courante à une cellule suivante sans déformation au travers des retards élémentaires 92 successifs, la durée de prise d'échantillon est la même pour toutes les cellules du réseau matriciel. Elle est égale à la durée de l'impulsion.

Il a été signalé plus haut que la durée de la somme des L retards individuels d'une ligne à retard 9 est contrôlée pour qu'elle reste égale à la durée séparant deux sorties consécutives du registre à décalage 6 de commande d'écriture.

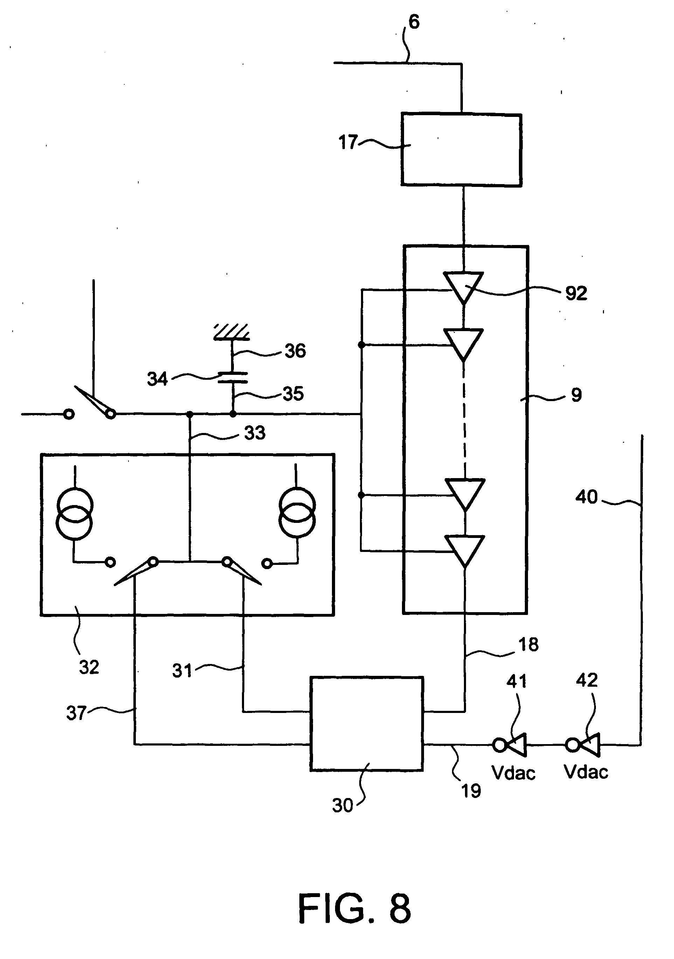

Le réglage du retard apporté par chaque retard élémentaire ou demi retard élémentaire, peut être effectué de façon en elle-même connue par contrôle d'une tension Vcom. Ce réglage sera maintenant expliqué en relation avec la figure 8.

Un système d'asservissement permet de fixer la tension de consigne Vcom de façon à ce que le délai d'une cellule soit égal à 1/(L x Fp). Chaque colonne possède son propre asservissement.

Chacun des derniers retards élémentaires de chaque ligne à retard 9 est connecté à une première entrée 18 d'un comparateur de phase 30 propre à ladite ligne 9. Une seconde entrée 19 du comparateur de phase 30 est connectée à une sortie d'un générateur d'un signal de référence provenant du registre à décalage 40. Des sorties 31 37 du comparateur de phase 30 sont connectées à des entrées positive et négative respectivement d'une pompe de charge 32 en elle-même connue comportant un générateur de courant positif et un générateur de courant négatif. Une sortie 33 de la pompe de charge 32 est connectée à une borne 35 d'une capacité 34 dont l'autre borne 36 est connectée à une source de tension de référence.

Comme représenté, figure 8, la sortie du registre à décalage 40 alimentant la colonne 12 dont le temps de parcours est contrôlé, est connecté à l'entrée 19 du comparateur de phase 30 au travers de deux inverseurs 41, 42.

Le fonctionnement est le suivant.

La phase du front arrière du signal issu du dernier retard élémentaire 92 de la ligne à retard 9 d'une colonne 12 est comparée dans le comparateur de phase 30 au front arrière du signal de référence en provenance du registre 40. Si le signal issu du dernier retard élémentaire 92 de la ligne à retard 9 est en avance sur le signal de référence, le comparateur de phase 30 active la pompe de charge 32 qui injecte une charge positive proportionnelle au décalage en temps dans la capacité 34. La tension Vcom présente sur la borne 35 augmentera et par conséquent le temps de propagation dans les inverseurs 93, 94 constituant ensemble chacun des retards élémentaires d'une ligne à retard 9 sera plus grand, ce qui aura tendance à remettre en phase le signal issu de la ligne à retard 9 et le signal de référence.

Inversement, si le signal issu du dernier retard élémentaire 92 de la ligne à retard 9 est en retard sur le signal de référence, la pompe de charge doit injecter une charge négative dans la capacité 32 afin d'accélérer le temps de transit dans les inverseurs 92, 93.

Avant la comparaison, les deux inverseurs 41, 42 à fronts de montée contrôlés par une tension extérieure (Vdac)retardent le signal de référence introduit sur l'entrée 19 du comparateur de phase 30. La tension Vdac est fixée de façon à compenser le retard induit par le bloc de mise en forme 17. Elle permet de plus d'ajuster le retard au temps de parcours nominal de la ligne 9, par exemple exactement 20ns dans l'exemple ici commenté où les retards élémentaires 92 des 20 lignes sont de 1 ns, avec une grande précision.

Du fait que dans le mode de réalisation qui vient d'être décrit, le temps de parcours de chaque colonne 12 par l'impulsion dont les fronts de montée ou de descente constituent les signaux de commande de début et de fin de capture du signal analogique est contrôlé pour être égal à la durée de la période du signal d'horloge commandant le passage d'une colonne d'enregistrement à la suivante, on est sûr qu'il n'y a pas enregistrement simultané d'échantillons ou manque d'échantillons lors du passage d'une colonne d'enregistrement à la suivante.

Le mode de réalisation des validations sera maintenant expliqué. Il a été vu plus haut que la fréquence d'échantillonnage pouvait être diminuée par saut de lignes d'enregistrement. Une ligne est nécessairement non enregistrée si les commutateurs 27a, 27b de la figure 6 partie A sont ouverts ou si les portes ET 24a ou 24b ne reçoivent pas le signal de validation sur l'une de leurs entrées respectives. Ce signal de validation permettant de valider une ligne est reçu de registres à décalage 15-1 et 15-2 représentés figures 3 et 4. Le registre à décalage 15-1 est couplé à la sortie de rang C/2 + 1 du registre à décalage d'écriture 6. Le registre à décalage 15-2 est couplé de façon similaire à la première sortie du registre à décalage d'écriture 6. Le registre à décalage 15-1 comporte autant de sorties décalées qu'il y a de lignes. Ces sorties sont couplées aux entrées de validation des cellules 2 des C/2 premières colonnes 12. Dans le cas d'un réseau matriciel d'enregistrement replié comme décrit en relation avec la figure 2, il s'agit des colonnes 12 de rang physique pair c'est à dire des colonnes dont le parcours d'enregistrement intervient en premier. De même le registre à décalage 15-2 comporte autant de sorties décalées qu'il y a de lignes. Ces sorties sont couplées aux entrées de validation des cellules 2 des C/2 dernières colonnes 12, c'est à dire des colonnes dont le parcours d'enregistrement intervient en dernier. Dans le cas d'un réseau matriciel d'enregistrement replié comme décrit en relation avec la figure 2, il s'agit des colonnes 12 de rang physique impair. Il convient à ce stade de faire remarquer que le rang de, parcours d'enregistrement des colonnes ne correspond pas à leur rang physique. Il est signalé aussi qu'une entrée de validation est une entrée numérique appliquée à la commande des interrupteurs 27 ou à une entrée de porte ET 24 dans le cas de la figure 6 partie B. Ainsi selon ce mode de réalisation on peut dire que le dispositif selon l'invention comporte au moins un registre à décalage de validation de lignes ayant au moins autant de sorties décalées que de lignes du réseau matriciel 10, chacun des au moins un dit registre de validation ayant une entrée couplée à l'une des sorties 8 du registre à décalage 6 d'écriture, chaque sortie décalée de ce registre étant couplée respectivement à une partie au moins des entrées numériques des cellules 2 de chacune des lignes 13.

Le fonctionnement est le suivant.

Les registres 15-1 (colonnes physiques paires) et 15-2 (colonnes physiques impaires) permettent l'accès aux fréquences d'échantillonnage comprises entre Fp et (L x Fp). Ces deux registres à décalage de chacun L sorties décalées permettent de générer les commandes d'autorisation d'écriture enw et enw*). Une sortie ayant par exemple un rang 1 du registre 15-1 porte la commande d'autorisation d'écriture enw (1, pair) des C/2 cellules mémoires de la ligne de rang 1 appartenant aux colonnes paires de cette ligne. De même, la sortie de rang 1 du registre 15-2 constitue la commande d'autorisation d'écriture enw (1,impair) des C/2 cellules mémoires appartenant aux colonnes impaires de la ligne de rang 1 du réseau matriciel de cellules 2.

Lors de l'initialisation du circuit, les registres 15-1 et 15-2 sont tous les deux chargés avec un mot de L bits dépendant de la fréquence d'échantillonnage sélectionnée. A cette fin, chaque registre 15-1 et 15-2 est couplé de façon en elle-même connue et non représenté figures 3 et 4 à un générateur de mots. Ce mot a la particularité de retrouver la même valeur après un nombre de décalages égal au diviseur de la fréquence maximum autorisée. La fréquence maximum autorisée dépend de la fréquence d'horloge et du nombre de lignes comme expliqué plus haut. Les valeurs de division autorisées sont les valeurs correspondant aux diviseurs entiers de L, par exemple 1, 2, 4, 5, 10 20 dans le cas de 20 lignes ou double lignes.

Le registre 15-1 recevra une commande initialisant un décalage vers le bas d'un mot de validation lorsque le pointeur de colonne du registre à décalage 6, qui détermine le parcours d'enregistrement des colonnes, passera à la colonne C/2 + 1. Le registre 15-2 recevra quant à lui la commande de décalage vers le bas du même mot de validation lorsque le pointeur de colonne repassera à la première colonne de rang pair. Le temps d'établissement du signal issu des registres de validation peut donc être relativement lent (durée < C/(2*Fp), ce qui permet de le rendre non perturbant pour le signal analogique à enregistrer.

Un tableau annexé à la présente description résume les valeurs d'initialisation des registres 15-1 et 15-2 en fonction de la fréquence d'échantillonnage désirée dans le cas de l'utilisation d'un réseau matriciel 10 à 20 lignes ou doubles lignes et d'une fréquence d'horloge Fp = 50Mhz :
lorsque la fréquence est maximum, diviseur 1, les 20 lignes sont enregistrées à la fréquence maximum, par exemple 1 GHz correspondant à 20 fois la fréquence principale d'horloge Fp. Toutes les lignes sont validées. Le mot de validation est composé de 20 valeurs hautes 1.

Lorsque la fréquence est divisée par 2, au cours d'un premier passage on enregistre une ligne sur 2. Le mot de validation est composé de 10 valeurs basses 0, alternées avec 10 valeurs hautes 1. Lors d'un premier passage les cellules 2 d'une ligne sur deux de chaque colonne enregistrent une valeur analogique. Lorsque les C/2 colonnes paires constituant les colonnes de la première partie du parcours d'enregistrement sont enregistrées le pointeur de colonne du registre à décalage d'écriture 6 arrive à la sortie de rang C/2 + 1. Le registre à décalage 15-1 reçoit un signal qui va faire avancer le mot de validation d'une sortie en sorte que les partie de lignes composant les C/2 premières colonnes initialement validées par un 1 vont être invalidées par un 0 et que, au contraire les parties de lignes invalidées par un 0 vont être validées par un 1. Ainsi après écriture des C/2 dernières colonnes lorsque le pointeur de colonne sera revenu à la première colonne ce sont les cellules des lignes de rang impair qui vont être enregistrées. Au début de l'enregistrement des C/2 premières colonnes, le registre 15-2 reçoit le signal en provenance de la première sortie du registre à décalage d'écriture 6 et fait avancer d'une sortie le mot de validation. Les cellules des parties de lignes impaires des C/2 dernières colonnes se trouvent validées alors que les cellules de lignes de rang pair se trouvent invalidées en sorte que lorsque l'écriture de la colonne de rang C/2 + 1 sera commencée, les cellules des parties de lignes appartenant à des colonnes de rang impair seront enregistrées. Le cycle se répète jusqu'à ce que l'enregistrement soit arrêté par une commande de fin d'enregistrement qui ne sera pas commentée ici.

Du fait que le mot de validation a la propriété de se régénérer modulo le diviseur de la fréquence maximum, dans l'exemple ici commenté après 2 décalages, l'enregistrement peut continuer aussi longtemps que souhaité. Toutes les cellules 2 du réseau matriciel peuvent recevoir un enregistrement en sorte que quel que soit le diviseur autorisé retenu, le réseau matriciel pourra toujours contenir un nombre de valeurs analogiques enregistrées égal au nombre des cellules du réseau matriciel. Lorsque le diviseur est 4, cas de la troisième ligne, il faudra 4 passages pour enregistrer toutes les cellules 2 du réseau matriciel.

Ainsi le dispositif de réalisation de l'invention comporte dans ce mode particulier de réalisation deux registres à décalage 15-1, 15-2 de validation de lignes ayant chacun au moins autant de sorties décalées que de lignes du réseau matriciel 10, un premier registre 15-1 et un second registre 15-2 le premier registre 15-1 ayant une entrée couplée à une sortie du registre à décalage 6 d'écriture ayant un premier rang de parcours, le second registre 15-2 ayant une entrée couplée à une seconde sortie du registre à décalage 6 d'écriture ayant un second rang de parcours différent du premier rang, la colonne 12 couplée à la première sortie de validation et les colonnes couplées aux sorties situées dans un parcours d'enregistrement entre la première sortie de validation et la seconde sortie de validation constituant ensemble une première partie du réseau matriciel 10, la colonne 12 couplée à la seconde sortie de validation et les colonnes couplées aux sorties situées dans le parcours d'enregistrement entre la seconde sortie de validation et la première sortie de validation constituant ensemble une seconde partie du réseau matriciel 10, chaque sortie du premier registre 15-1 étant couplée à une entrée numérique de validation des cellules d'une seconde partie de ligne appartenant à la seconde partie du réseau matriciel 10 et chacune des sorties du second registre 15-2 étant couplée à une entrée numérique de validation des cellules d'une première partie de ligne appartenant à la première partie du réseau matriciel 10.

Le mode de fonctionnement de validation qui vient d'être décrit correspond à un procédé de capture d'échantillons analogiques caractérisé en ce que on divise une fréquence maximum de prise d'échantillon par un diviseur entier m du nombre de lignes ou paires de lignes L, cette fréquence correspondant au cas où des échantillons consécutifs sont capturés dans des cellules de capture appartenant à une même colonne mais situées sur des lignes ou paires de lignes consécutives,
a) en autorisant la capture d'échantillon pour une cellule d'une première ligne du réseau matriciel,
b) puis en invalidant la prise d'échantillon dans les (m - 1) cellules de ladite colonne appartenant aux lignes suivant de façon consécutive ladite première ligne,
c) puis en autorisant la prise d'échantillon pour la m_{ième} ligne suivant ladite première ligne
d) et en recommençant de la même manière les étapes a, b, et c pour les m lignes suivantes ceci jusqu'à atteindre la dernière ligne du réseau matriciel,
e) en recommençant de la même manière pour chacune des colonnes jusqu'à ce que toutes les cellules des lignes autorisées contiennent des échantillons
f) en recommençant les étapes a) à e) à partir d'une deuxième ligne du réseau matriciel, puis éventuellement d'une troisième ligne et en recommençant jusqu'à commencer par la (m - 1)_{ième} ligne, en sorte qu'après cette dernière étape toutes les cellules du réseau matriciel contiennent un échantillon analogique.

Le mode de lecture du réseau matriciel ne fait pas l'objet de l'invention. Il sera commenté brièvement ci-dessous pour information. D'après ce qui a été expliqué ci-dessus on comprend que l'enregistrement se reproduit de façon indéfinie, les cellules déjà écrites étant réécrites après que toutes les cellules ont reçu un enregistrement, les derniers enregistrements effaçant les premiers enregistrements effectués, (FIFO, first in first out). Lorsque l'arrêt d'enregistrement intervient, la dernière cellule écrite peut être n'importe laquelle des cellules du réseau matriciel. Pour être cohérent il faudra pouvoir retrouver lors de la lecture la cellule suivant immédiatement dans l'ordre d'écriture la dernière cellule enregistrée. On remarque que la colonne en cours d'enregistrement au moment de l'arrêt est connue par l'état au moment de l'arrêt d'enregistrement, du registre d'écriture 6. De façon avantageuse afin de séparer la lecture de l'écriture le registre d'écriture 6 est recopié dans un registre de recopie de lecture non représenté. Un signal d'arrêt d'écriture STOP commande l'arrêt de l'horloge principale Fp. L'arrêt de l'horloge principale entraîne notamment un gel des registres d'écriture 6, de lecture et 15-1, 15-2 de validation. Les registres ainsi gelés seront acquis à la lecture du réseau matriciel pour permettre la reconstruction des données. Le signal d'arrêt d'écriture STOP est de référence transformé en une signal synchrone de Fp, c'est à dire intervenant une durée prédéterminée après un front arrière du signal Fp. La durée prédéterminée sera choisi pour que l'arrêt effectif de l'enregistrement par ouverture des interrupteurs 21 intervienne sur une cellule appartenant à une ligne de rang prédéterminée. Ainsi connaissant la colonne d'arrêt et la ligne d'arrêt, on connaîtra la cellule de départ de la lecture. Connaissant l'ordre d'écriture par la connaissance des registres de validation on pourra reconstituer l'ordre de lecture. Le contenu des cellules pourra ainsi être lu colonne par colonne par la commande des interrupteurs de lecture 25. Les valeurs analogiques sont amplifiées, multiplexées, et converties en valeurs numériques et stockées dans une mémoire de lecture pour être lues à une fréquence qui pourra être choisie par un utilisateur. Les résultats de lecture peuvent, de façon en elle-même connue, être réordonnés dans l'ordre d'écriture et présentés sur un écran sous forme de courbe ou sous toute autre forme.

### Annexe

| Fréquence d'échantillonnage | Valeur du diviseur de fréquence de la fréquence maximum | Valeur initiale du registre de validation (hexadécimal) | Valeur initiale du registre de validation (binaire) |
|---|---|---|---|
| 1GHz | 1 | $FFFFF | 11111111111111111111 |
| 500MHz | 2 | $55555 | 01010101010101010101 |
| 250MHz | 4 | $11111 | 00010001000100010001 |
| 200MHz | 5 | $08421 | 00001000010000100001 |
| 100MHz | 10 | $00401 | 00000000010000000001 |
| 50MHz | 20 | $00001 | 00000000000000000001 |

## Revendications

1. Echantillonneur analogique (1) d'enregistrement de données analogiques relatives à un signal comportant :
- au moins un bus (5, 5a, 5b) analogique portant le signal à enregistrer ;
- un réseau (10) matriciel de cellules (2) de capture et d'enregistrement rangées en lignes (13) et colonnes (12), chacune des cellules (2) ayant au moins une entrée (3) analogique couplée au, au moins un bus (5a) analogique et au moins une entrée numérique, (11-1, 23, 26, 27) chacune des colonnes (12) ayant une entrée (8-1) de colonne (12) couplée à une entrée numérique (11-1) de chaque cellule (2) de ladite colonne (12) ;
- un registre à décalage (6) d'écriture ayant une entrée (7) pour recevoir un signal d'horloge et une pluralité de sorties (8) décalées couplées aux entrées (8-1) de colonnes (12) du réseau matriciel (10) ;
- pour chaque colonne (12), une ligne à retard (9) associée ayant une entrée (8-1) de la ligne à retard (9) et des sorties (11) successives décalées en nombre égal ou supérieur au nombre de lignes (9) du réseau matriciel (10), l'entrée (8-1) de la ligne à retard (9) constituant l'entrée de colonne (12), l'entrée (8-1) de colonne (12) étant couplée à l'une des entrées numériques (11-1) des cellules (2) de la colonne (12) par l'intermédiaire de ladite ligne à retard (9), chaque ligne à retard (9) étant formée par une succession de retards élémentaires (92), un premier retard (92) couplé à une entrée numérique (21) d'une cellule (2) de la première ligne (13), chacun des retards élémentaires (92) suivants couplé de façon biunivoque à une entrée numérique d'une cellule (2) de l'une des lignes (13) suivantes et un dernier retard (92) élémentaire couplé à une entrée numérique d'une cellule (2) de la dernière ligne, (13), ledit
échantillonneur analogique étant **caractérisé en ce que** :
- ladite ou lesdites entrée(s) numérique(s) (11-1) de cellule (2) couplée(s) de façon biunivoque à l'un des retards (92) élémentaires de ladite ligne à retard (9) constitue(nt) successivement l'entrée de commande du début et de la fin d'une prise d'échantillon pour ladite cellule (2),
- il comporte au moins pour une ligne (9) à retard associée à une colonne (12) ou pour une ligne (91) à retard supplémentaire un comparateur de phase (30) recevant sur une première entrée (18) un signal en provenance de ladite ligne à retard (9, 91) et sur une seconde entrée (19) un signal de référence, une sortie au moins dudit comparateur de phase (30) étant couplée à une pompe de charge (32) dont une sortie (33) est couplée à des moyens commandant une tension de réglage des retards élémentaires (92).

2. Echantillonneur analogique (1) d'enregistrement de données analogiques selon la revendication 1, **caractérisé en ce qu'**une ligne (9) à retard est associée à chaque colonne (12), et ledit comparateur de phase (30) recevant sur une première entrée (18) le signal en provenance du dernier retard (92) de ladite ligne à retard (9) associée à cette colonne (12) et sur une seconde entrée (19) un signal de référence qui est une image du signal d'entrée de ladite ligne à retard (9) associé à cette colonne (12) retardé d'une durée constante, par exemple une période d'horloge du registre à décalage d'écriture (6) ou d'un autre registre à décalage (40) recevant le même signal d'horloge que le registre à décalage d'écriture (6), une sortie au moins dudit comparateur de phase (30) étant couplée à une pompe de charge (32) dont une sortie (33) est couplée à des moyens commandant une tension de réglage des retards élémentaires (92).

3. Echantillonneur analogique (1) d'enregistrement de données analogiques selon la revendication 1 ou 2, **caractérisé en ce que** les sorties (8) du registre à décalage d'écriture (6) sont couplées aux entrées (8-1) des lignes à retard (9) au travers de blocs (17) de mise en forme d'une impulsion ces blocs réglant notamment la durée de l'impulsion.

4. Echantillonneur analogique (1) d'enregistrement de données analogiques selon l'une des revendications 1 à 3, **caractérisé en ce que** chaque retard élémentaire (92) est composé de deux demi retards élémentaires (93, 94) placés en série, un premier (93) et un second (94) chaque demi retard élémentaire (93, 94) ayant une sortie numérique couplée à une entrée numérique d'une cellule (2).

5. Echantillonneur analogique (1) d'enregistrement de données analogiques selon l'une des revendications 1 à 4, **caractérisé en ce que** le réseau (10) matriciel de cellules (2) d'enregistrement est replié sur lui-même, le registre à décalage (6) d'écriture comportant un coude (63) à 180° formant ainsi une partie (61) aller située avant le coude (63) et une partie (62) retour située après le coude (63), des colonnes (12) et leurs lignes à retard (9) associées couplées à des sorties (8) du registre à décalage (6) d'écriture situées sur la partie (62) retour étant intercalées entre des colonnes (12) et leurs lignes à retard (9) associées couplées à des sorties (8) du registre à décalage (6) d'écriture situées sur la partie (61) aller.

6. Echantillonneur analogique (1) d'enregistrement de données analogiques selon l'une des revendications 1 à 5, **caractérisé en ce que** le bus (5) analogique d'entrée est divisé pour alimenter des divisions (5-1, . . .5-L), chaque division correspondant à une ligne (13) du réseau matriciel (10), et chacune de ces divisions (5-1, ... 5-L) portant un amplificateur suiveur (14).

7. Echantillonneur analogique (1) d'enregistrement de données analogiques selon l'une des revendications 1 à 6, **caractérisé en ce qu'**il comporte en outre au moins un registre à décalage (15-1, 15-2) de validation de ligne ayant au moins autant de sorties décalées que de lignes du réseau matriciel (10), chacun des au moins un dit registres (15-1, 15-2) de validation ayant une entrée couplée à l'une des sorties (8) du registre à décalage (6) d'écriture, chaque sortie décalée de ce registre étant couplée respectivement à une partie au moins des entrées numériques des cellules (2) de chacune des lignes (13).

8. Echantillonneur analogique (1) d'enregistrement de données analogiques selon la revendication 7, **caractérisé en ce qu'**il comporte deux registres à décalage (15-1, 15-2) de validation de lignes ayant chacun au moins autant de sorties décalées que de lignes du réseau matriciel (10), un premier registre (15-1) et un second registre (15-2) le premier registre (15-1) ayant une entrée couplée à une sortie du registre à décalage (6) d'écriture ayant un premier rang de parcours, le second registre (15-2) ayant une entrée couplée à une seconde sortie du registre à décalage (6) d'écriture ayant un second rang de parcours différent du premier rang, la colonnes (12) couplée à la première sortie de premier rang et les colonnes (12) couplées aux sorties situées dans un parcours d'enregistrement entre la première sortie de validation et la seconde sortie de validation constituant ensemble une première partie du réseau matriciel (10), la colonnes (12) couplées à la seconde sortie de second rang et les colonnes (12) couplées aux sorties situées dans le parcours d'enregistrement entre la seconde sortie de second rang et la première sortie de premier rang constituant ensemble une seconde partie du réseau matriciel (10), chaque sortie du premier registre (15-1) étant couplée à une entrée numérique de validation des cellules (2) d'une seconde partie de ligne appartenant à la seconde partie du réseau matriciel (10) et chacune des sorties du second registre étant couplée à une entrée numérique de validation des cellules (2) d'une première partie de ligne appartenant à la première partie du réseau matriciel (10).

9. Echantillonneur analogique selon l'une des revendications 7 ou 8, **caractérisé en ce que** chaque registre de validation (15-1, 15-2) a une entrée qui peut être couplée à un générateur d'un mot de validation.

10. Echantillonneur analogique (1) d'enregistrement de données analogiques selon l'une des revendications 6 à 9, **caractérisé en ce que** chaque cellule (2) du réseau comporte une capacité (22) ayant deux bornes une première (22a) et une seconde (22b), la première borne (22a) étant couplée par l'intermédiaire d'un premier interrupteur commandable (21a) appartenant à des premiers moyens de commutation (21) à une division (5-1, 2-2, ... 5L) du bus (5), la seconde borne (22b) étant couplée à une partie retour (5b) du bus (5) à potentiel constant par l'intermédiaire d'un second interrupteur commandable (21b) appartenant aux dits premiers moyens de commutation (21), une commande (23a, 23b) de chacun de ces interrupteurs (21a, 21b) étant couplée à des entrées numériques de chacune des cellules (2).

11. Echantillonneur analogique (1) d'enregistrement de données analogiques selon la revendication 10, **caractérisé en ce que** le second interrupteur (21b) appartenant aux dits premiers moyens de commutation (21), de chaque cellule (2) a son entrée de commande connectée à un retard élémentaire ou demi retard élémentaire de la ligne à retard (9) qui est situé en amont d'une sortie d'un retard élémentaire (92) ou demi retard élémentaire (93, 94) auquel est connectée une entrée de commande du premier interrupteur (21a) appartenant aux dits premiers moyens de commutation (21).

12. Echantillonneur analogique (1) d'enregistrement de données analogiques selon l'une des revendications 10 ou 11, **caractérisé en ce que** le premier interrupteur (21a) appartenant aux dits premiers moyens de commutation (21) est formé par deux transistors branchées en parallèle un transistor NMOS et un transistor PMOS.

13. Echantillonneur analogique (1) d'enregistrement selon la revendication 1, **caractérisé en ce qu'**il comporte deux bus analogiques d'entrée un premier destiné à être connecté à une source du signal à échantillonner à une première polarité, un second destiné à être connecté à un inverseur de polarité recevant le signal à échantillonner et délivrant un signal à échantillonner à une seconde polarité inverse de la première, les deux bus analogiques d'entrée étant divisés pour alimenter des divisions, chaque division correspondant à une ligne du réseau matriciel et chacune de ces divisions portant un amplificateur suiveur (14), les lignes étant arrangées en paires de lignes, chaque paire de lignes comportant une ligne du réseau matriciel de rang impair et une ligne du réseau matriciel de rang pair, les lignes d'une paire ayant des rangs consécutifs, chaque ligne de rang impair ayant ses cellules couplées à une division du bus portant le signal de première polarité et chaque ligne de rang pair ayant ses cellules couplées à une division du bus portant le signal de seconde polarité.

14. Procédé de capture d'échantillons analogiques d'un signal analogique présent sur un bus analogique, dans des cellules formant ensemble un réseau matriciel de cellules ayant C colonnes (12) et L lignes (13) ou paires de lignes, C et L désignant des nombres entiers, chaque colonne constituée par une succession en série de retards élémentaires ayant une entrée de colonne pour recevoir une impulsion ayant un front montant et un front descendant, ladite impulsion provenant d'un registre à décalage commandé par un signal d'horloge, dans lequel :
- un signal de début de capture d'échantillon pour une cellule est reçu sur une première entrée numérique de ladite cellule
- et dans lequel un signal de fin de capture d'échantillon est reçu sur une seconde entrée numérique de ladite cellule
**caractérisé en ce que** :
- les signaux de début et de fin de prise d'échantillon sont constitués par les fronts montant ou descendant de ladite impulsion, ces fronts étant reçus successivement de l'un des retards élémentaires de ladite colonne sur une entrée numérique physiquement unique constituant successivement la première entrée numérique de commande de début et la seconde entrée numérique de commande de fin de capture d'échantillon, ou étant reçus respectivement de retards élémentaires de ladite colonne sur une première entrée numérique de commande de début puis sur une deuxième entrée numérique de commande de fin de capture d'échantillon,
- pour au moins une ligne à retard (9) associée avec une colonne (12) ou pour une ligne à retard supplémentaire (91), une comparaison de phase est effectuée entre un signal de ladite ligne à retard (9, 91) et un signal de référence, le résultat de la comparaison de phase contrôlant une pompe de charge (32) dont la sortie contrôle à son tour une tension de régulation des délais élémentaires (92).

15. Procédé de capture d'échantillons analogiques selon la revendication 14, **caractérisé en ce que** l'impulsion comportant les fronts montant et descendant constituant les signaux de commande de début et de fin de prise d'échantillon est propagé d'une cellule courante à une cellule suivante en sorte que la durée de prise d'échantillon est la même pour toutes les cellules du réseau matriciel.

16. Procédé de capture d'échantillons analogiques selon l'une des revendications 14 ou 15 **caractérisé, en ce que** on divise une fréquence maximum de prise d'échantillon par un diviseur entier m du nombre de lignes ou paires de lignes L, cette fréquence correspondant au cas où des échantillons consécutifs sont capturés dans des cellules de capture appartenant à une même colonne mais situées sur des lignes ou paires de lignes consécutives,
a) en autorisant la capture d'échantillon pour une cellule d'une première ligne du réseau matriciel,
b) puis en invalidant la prise d'échantillon dans les (m - 1) cellules de ladite colonne appartenant aux lignes suivant de façon consécutive ladite première ligne,
c) puis en autorisant la prise d'échantillon pour la m_{iéme} ligne suivant ladite première ligne
d) et en recommençant de la même manière les étapes a, b, et c pour les m lignes suivantes ceci jusqu'à atteindre la dernière ligne du réseau matriciel,
e) en recommençant de la même manière pour chacune des colonnes jusqu'à ce que toutes les cellules des lignes autorisées contiennent des échantillons
f) en recommençant les étapes a) à e) à partir d'une deuxième ligne du réseau matriciel, puis éventuellement d'une troisième ligne et en recommençant jusqu'à commencer par la (m - 1)_{iéme} ligne, en sorte qu'après cette dernière étape toutes les cellules du réseau matriciel contiennent un échantillon analogique.

17. Procédé de capture d'échantillons analogiques selon l'une des revendications 14 à 16 **caractérisé en ce que** au reçu du signal de fin de prise d'échantillon pour une cellule quelconque, on déconnecte tout d'abord la cellule d'une ligne de potentiel à potentiel constant et ensuite on déconnecte ladite cellule du bus analogique portant le signal analogique à échantillonner.

## Claims

1. An analog sampler (1) for recording analog data relative to a signal comprising:
- at least one analog bus (5, 5a, 5b) carrying the signal to be recorded;
- a matrix array (10) of capture and recording cells (2) arranged in rows (13) and columns (12), each of the cells (2) having at least one analog input (3) coupled to at least one analog bus (5a) and at least one digital input (11-1, 23, 26, 27), each of the columns (12) having a column (12) input (8-1) coupled to a digital input (11-1) of each cell (2) of said column (12);
- a write shift register (6) having an input (7) for receiving a clock signal and a plurality of shifted outputs (8) coupled to the inputs (8-1) of columns (12) of the matrix array (10);
- for each column (12) an associated delay line (9) having an entry (8-1) of the delay line (9) and successive shifted outputs (11) in a number equal to or greater than the number of lines (9) of the matrix array (10), the input (8-1) of the delay line (9) constituting the column (12) input, the column (12) input (8-1) being coupled to one of the digital inputs (11-1) of cells (2) of the column (12) by means of said delay line (9), each delay line (9) being formed by a succession of elementary delays (92), a first delay (92) coupled to a digital input (21) of a cell (2) of the first row (13), each of the following elementary delays (92) coupled biunivocally to a digital input of a cell (2) of one of the following lines (13) and a last elementary delay (92) coupled to a digital input of a cell (2) of the last line (13) ;
said analog sampler being **characterized in that**:
- said digital input(s) (11-1) of a cell (2) coupled biunivocally to one of the elementary delays (92) of said delay line (9) constitutes(s) successively the start and end control input of sampling for said cell (2),
- it comprises at least for one delay line (9) associated with a column (12) or for a supplementary delay line (91) a phase comparator (30) receiving via a first input (18) a signal from said delay line (9, 91) and via a second input (19) a reference signal, one output at least of said phase comparator (30) being coupled to a charge pump (32), whose one output (33) is coupled to means controlling a regulating voltage of the elementary delays (92).

2. The analog sampler (1) for recording analog data according to claim 1, **characterized in that** a delay line (9) is associated with each column (12), and said phase comparator (30) receiving via a first input (18) the signal from the last delay (92) of said delay line (9) associated with this column (12) and via a second input (19) a reference signal that is an image of the input signal of said delay line (9) associated with this column (12) delayed by a constant duration; for example, a clock period of the write shift register (6) or another shift register (40) receiving the same clock signal as the write shift register (40) receiving the same clock signal as the write shift register (6), one output at least of said phase comparator (30) being coupled to a charge pump (32), whose one output (33) is coupled to means controlling a regulating voltage of the elementary delays (92).

3. The analog sampler (1) for recording analog data according to claim 1 or 2, **characterized in that** the outputs (8) of the write shift register (6) are coupled to delay line (9) inputs (8-1) via formatting blocks (17) of a pulse, said blocks regulating in particular the duration of the pulse.

4. The analog sampler (1) for recording analog data according to one of claims 1 to 3, **characterized in that** each elementary delay (92) is comprised of two elementary half-delays (93, 94) placed in series, a first one (93) and a second one (94), each elementary half-delay (93, 94) having a digital output coupled to a digital input of a cell (2).

5. The analog sampler (1) for recording analog data according to one of claims 1 to 4, **characterized in that** the matrix array (10) of recording cells (2) is folded upon itself, the write shift register (6) comprising a 180° bend (63) thus forming an outbound part (61) situated before the bend (63) and a return part (62) situated after the bend (63), columns (12) and their associated delay lines (9) coupled to outputs (8) of the write shift register (6) situated on the return part (62) being intercalated between the columns (12) and their associated delay lines (9) coupled to outputs (8) of the write shift register (6) situated on the outbound part (61).

6. The analog sampler (1) for recording analog data according to one of claims 1 to 5, **characterized in that** the analog input bus (5) is divided for supplying divisions (5-1, ... 5-L), each division corresponding to a row (13) of the matrix array (10), and each of these divisions (5-1, ... 5-L) carrying a follow-up amplifier (14).

7. The analog sampler (1) for recording analog data according to one of claims 1 to 6, **characterized in that** it comprises in addition at least one line validation shift register (15-1, 15-2) having at least as many shifted outputs as rows of the matrix array (10), each of the at least one said validation registers (15-1, 15-2) having an input coupled to one of the outputs (8) of the write shift register (6), each shifted output of this register being coupled, respectively, to one part at least of the digital inputs of the cells (2) of each of the rows (13).

8. The analog sampler (1) for recording analog data according to claim 7, **characterized in that** it comprises two line validation shift registers (15-1, 15-2) each having at least as many shifted outputs as rows of the matrix array (10), a first register (15-1) and a second register (15-2), the first register (15-1) having an input coupled to a write shift register (6) having a first pass ranking, the second register (15-2) having an input coupled to a second output of the write shift register (6) having a second pass ranking different from the first ranking, the columns (12) coupled to the first output of the first ranking and the columns (12) coupled to the outputs situated in a recording path between the first validation output and the second validation output together constituting a first part of the matrix array (10), the columns (12) coupled to the second output of the second ranking and the columns (12) coupled to the outputs situated in the recording path between the second output of the second ranking and the first output of the first ranking together constituting a second part of the matrix array (10), each output of the first register (15-1) being coupled to a digital validation input of the cells (2) of a second part of the line belonging to the second part of the matrix array (10) and each of the outputs of the second register being coupled to a digital validation input of the cells (2) of a first part of the line belonging to the first part of the matrix array (10).

9. The analog sampler according to one of claims 7 or 8, **characterized in that** each validation register (15-1, 15-2) has an input that can be coupled to a generator of a validation word.

10. The analog sampler (1) for recording analog data according to one of claims 6 to 9, **characterized in that** each cell (2) of the array comprises a capacitor (22) having two terminals: a first (22a) and a second (22b), the first terminal (22a) being coupled by means of a first controllable switch (21a) belonging to the first switching means (21) at a division (5-1, 2-2, ... 5L) of the bus (5), the second terminal (22b) being coupled to a return part (5b) of the bus (5) at constant potential by means of a second controllable switch (21b) belonging to the said first switching means (21), a control (23a, 23b) of each of these switches (21a, 21b) being coupled to digital inputs of each of the cells (2).

11. The analog sampler (1) for recording analog data according to claim 10, **characterized in that** the second switch (21b) belonging to said first switching means (21) of each cell (2) has its control input connected to an elementary delay or elementary half-delay of the delay line (9) that is situated upstream of an output of an elementary delay (92) or elementary half-delay (93, 94) to which a command input of the first switch (21a) belonging to the said first switching means (21) is connected.

12. The analog sampler (1) for recording analog data according to one of claims 10 or 11, **characterized in that** the first switch (21a) belonging to the said first switching means (21) is formed by two branched transistors in parallel, an NMOS transistor and a PMOS transistor.

13. The analog sampler (1) for recording according to claim 1, **characterized in that** it comprises two analog input buses, a first one for being connected to a source of the signal to be sampled at a first polarity, a second for being connected to a polarity inverter receiving the signal to be sampled and supplying a signal to be sampled at a second polarity that is the inverse of the first polarity, the two analog input buses being divided in order to supply the divisions, each division corresponding to a row of the matrix array and each of these divisions having a follow-up amplifier (24), the rows being arranged in pairs of rows, each pair of rows comprising one row of the matrix array of odd ranking and one row of the matrix array of even ranking, the rows of one pair having consecutive rankings, each row of odd ranking having its cells coupled to a division of the bus carrying the signal of the first polarity and each even ranked row having its cells coupled to a division of the bus carrying the signal of the second polarity.

14. A method for capturing analog samples of an analog signal present on an analog bus in cells together forming a matrix array of cells having C columns (12) and L rows (13) or pairs of rows, C and L designating integer numbers, each column being comprised by a serial succession of elementary delays having a column input for receiving a pulse having a rising edge and a descending edge, said pulse coming from a shift register controlled by a clock signal, wherein:
- a sample capture start signal for a cell is received on a first digital input of said cell;
- and in which an end of sample capture signal is received on a second digital input of said cell;
**characterized in that**
- the start and end sampling operation signals are constituted by the ascending or descending edges of said pulse, these edges being received successively from one of the elementary delays of said column on a physically unique digital input constituting successively the first digital control start input and the second digital control end of sample capture input, or being received, respectively, from elementary delays of said column on a first digital control start input then on a second digital control end of sample capture input,
- at least for one delay line (9) associated with a column (12) or for a supplementary delay line (91), a phase comparison is carried out between a signal from said delay line (9, 91) and a reference signal, the result of the phase comparison controlling a charge pump (32), the output of which controlling in turn a regulating voltage of the elementary delays (92).

15. The analog sample capture method according to claim 14, **characterized in that** the pulse comprising the ascending and descending edges constituting the start and end control signals of the sampling operation is propagated by a current cell to a following cell such that the duration of sampling is the same for all of the cells of a matrix array.

16. The analog sample capture method according to one of claims 14 or 15, **characterized in that** a maximum rate of sampling is divided by an integer divisor m of the number of rows or pairs of rows L, this rate corresponding to the case, wherein the consecutive samples are captured in capture cells belonging to a same column but situated on consecutive rows or pairs of rows,
a) by enabling sample capture for one cell of a first row of the matrix array;
b) then by invalidating the sampling operation in the (m - 1) cells of said column belonging to the rows consecutively following said first row;
c) then enabling the sampling operation for the m^{th} row following said first row;
d) and by restarting in the same fashion the steps a, b and c for the m following rows and this until reaching the last line of the matrix array;
e) by restarting in the same fashion for each of the columns until all of the cells of enabled rows contain samples;
f) by restarting steps a) to e) from a second row of the matrix array, then optionally from a third row and by restarting until starting with the (m - 1)^{th} row such that after this last step all of the cells of the matrix array contain an analog sample.

17. The analog sample capture method according to one of claims 14 to 16, **characterized in that** on receipt of the end of sampling signal for any cell, first of all the cell of a row on potential is disconnected from constant potential and then said cell is disconnected from the analog bus carrying the analog signal to be sampled.

## Patentansprüche

1. Analoger Abtaster (1) zur Speicherung von analogen Daten, die sich auf ein Signal beziehen, umfassend:
- wenigstens einen analogen Bus (5, 5a, 5b), der das zu speichernde Signal trägt;
- ein Matrixnetz (10) von Erfassungs- und Speicherzellen (2), die in Zeilen (13) und Spalten (12) angeordnet sind, wobei jede der Zellen (2) wenigstens einen analogen Eingang (3) hat, der mit dem wenigstens einen analogen Bus (5a) gekoppelt ist, sowie wenigstens einen digitalen Eingang (11-1, 23, 26, 27), wobei jede der Spalten (12) einen Eingang (8-1) der Spalte (12) hat, der mit einem digitalen Eingang (11-1) jeder Zelle (2) der Spalte (12) gekoppelt ist;
- ein Schreib-Schieberegister (6) mit einem Eingang (7) zum Empfangen eines Taktsignals und einer Mehrzahl von verschobenen Ausgängen (8), die mit den Eingängen (8-1) der Spalten (12) des Matrixnetzes (10) gekoppelt sind;
- für jede Spalte (12) eine zugeordnete Verzögerungsleitung (9) mit einem Eingang (8-1) der Verzögerungsleitung (9) und aufeinanderfolgenden verschobenen Ausgängen (11), deren Zahl größer oder gleich der Zahl der Zeilen (9) des Matrixnetzes (10) ist, wobei der Eingang (8-1) der Verzögerungsleitung (9) den Eingang der Spalte (12) bildet, wobei der Eingang (8-1) der Spalte (12) mit einem der digitalen Eingänge (11-1) der Zellen (2) der Spalte (12) mittels der Verzögerungsleitung (9) gekoppelt ist, wobei jede Verzögerungsleitung (9) durch eine Folge von Elementarverzögerern (92) gebildet ist, wobei ein erster Verzögerer (92) mit einem digitalen Eingang (21) einer Zelle (2) der ersten Zeile (13) gekoppelt ist, wobei jeder der folgenden Elementarverzögerer (92) in eineindeutiger Weise mit einem digitalen Eingang einer Zelle (2) der einen der folgenden Zeilen (13) gekoppelt ist und ein letzter Elementarverzögerer (92) mit einem digitalen Eingang einer Zelle (2) der letzten Zeile (13) gekoppelt ist, wobei der analoge Abtaster **dadurch gekennzeichnet ist, dass**:
- der oder die digitale Eingang/Eingänge (11-1) der Zelle (2), der/die in eineindeutiger Weise mit einem der Elementarverzögerer (92) der Verzögerungsleitung (9) gekoppelt ist/sind, nacheinander den Eingang zur Steuerung des Anfangs und des Endes einer Abtastung für die Zelle (2) bildet/bilden,
- er für wenigstens eine Verzögerungsleitung (9), die einer Spalte (12) zugeordnet ist, oder für eine weitere Verzögerungsleitung (91) einen Phasenkomparator (30) umfasst, der an einem ersten Eingang (18) ein Signal empfängt, das von der Verzögerungsleitung (9, 91) stammt, und an einem zweiten Eingang (19) ein Referenzsignal empfängt, wobei wenigstens ein Ausgang des Phasenkomparators (30) mit einer Ladungspumpe (32) gekoppelt ist, die einen Ausgang (33) hat, der mit einer Einrichtung gekoppelt ist, die eine Regelspannung der Elementarverzögerer (92) steuert.

2. Analoger Abtaster (1) zur Speicherung von analogen Daten nach Anspruch 1, **dadurch gekennzeichnet, dass** eine Verzögerungsleitung (9) jeder Spalte (12) zugeordnet ist, und dass der Phasenkomparator (30) an einem ersten Eingang (18) das Signal empfängt, das vom letzten Verzögerer (92) der dieser Spalte (12) zugeordneten Verzögerungsleitung (9) stammt, und an einem zweiten Eingang (19) ein Referenzsignal empfängt, das ein Bild des Eingangssignals der dieser Spalte (12) zugeordneten Verzögerungsleitung (9) ist, verzögert um eine konstante Dauer, beispielsweise um eine Taktperiode des Schreib-Schieberegisters (6) oder eines anderen Schieberegisters (40), welches das gleiche Taktsignal empfängt wie das Schreib-Schieberegister (6), wobei wenigstens ein Ausgang des Phasenkomparators (30) mit einer Ladungspumpe (32) gekoppelt ist, die einen Ausgang (33) hat, welcher mit einer Einrichtung gekoppelt ist, die eine Regelspannung der Elementarverzögerer (92) steuert.

3. Analoger Abtaster (1) zur Speicherung von analogen Daten nach Anspruch 1 oder 2, **dadurch gekennzeichnet, dass** die Ausgänge (8) des Schreib-Schieberegisters (6) mit den Eingängen (8-1) der Verzögerungsleitung (9) über Blöcke (17) zur Formung eines Pulses dieser Blöcke gekoppelt sind, die insbesondere die Dauer des Pulses regeln.

4. Analoger Abtaster (1) zur Speicherung von analogen Daten nach einem der Ansprüche 1 bis 3, **dadurch gekennzeichnet, dass** jeder Elementarverzögerer (92) zwei in Reihe angeordnete Halb-Elementarverzögerer (93, 94) umfasst, wobei jeder erste (93) und zweite (94) Halb-Elementarverzögerer (93, 94) einen digitalen Ausgang hat, der mit einem digitalen Eingang einer Zelle (2) gekoppelt ist.

5. Analoger Abtaster (1) zur Speicherung von analogen Daten nach einem der Ansprüche 1 bis 4, **dadurch gekennzeichnet, dass** das Matrixnetz (10) von Speicherzellen (2) auf sich selbst gefaltet ist, wobei das Schreib-Schieberegister (6) einen 180°-Bogen (63) umfasst, der somit ein Hin-Teil (61), das vor dem Bogen (63) liegt, sowie ein Rück-Teil (62), das hinter dem Bogen (63) liegt, bildet, wobei Spalten (12) und ihre zugeordneten Verzögerungsleitungen (9), die mit Ausgängen (8) des Schreib-Schieberegisters (6) gekoppelt sind, die am Rück-Teil (62) liegen, zwischen Spalten (12) und ihren zugeordneten Verzögerungsleitungen (9) eingefügt sind, die mit Ausgängen (8) des Schreib-Schieberegisters (6) gekoppelt sind, welche am Hin-Teil (61) liegen.

6. Analoger Abtaster (1) zur Speicherung von analogen Daten nach einem der Ansprüche 1 bis 5, **dadurch gekennzeichnet, dass** der analoge Eingangsbus (5) zur Versorgung von Unterteilungen (5-1, ..., 5-L) unterteilt ist, wobei jede Unterteilung einer Zeile (13) des Matrixnetzes (10) entspricht, und wobei jede dieser Unterteilungen (5-1, ..., 5-L) einen Begleitverstärker (14) trägt.

7. Analoger Abtaster (1) zur Speicherung von analogen Daten nach einem der Ansprüche 1 bis 6, **dadurch gekennzeichnet, dass** er ferner wenigstens ein Leitungsvalidierungs-Schieberegister (15-1, 15-2) umfasst, das mindestens so viele verschobene Ausgänge wie Zeilen des Matrixnetzes (10) hat, wobei jedes der wenigstens ein Validierungsregister (15-1, 15-2) einen Eingang hat, der mit einem der Ausgänge (8) des Schreib-Schieberegisters (6) gekoppelt ist, wobei jeder verschobene Ausgang dieses Registers jeweils mit wenigstens einem Teil der digitalen Eingänge der Zellen (2) jeder der Zeilen (13) gekoppelt ist.

8. Analoger Abtaster (1) zur Speicherung von analogen Daten nach Anspruch 7, **dadurch gekennzeichnet, dass** er zwei Leitungsvalidierungs-Schieberegister (15-1, 15-2) umfasst, von denen jedes wenigstens so viele verschobene Ausgänge wie die Zeilen des Matrixnetzes (10) hat, nämlich ein erstes Register (15-1) und ein zweites Register (15-2), wobei das erste Register (15-1) einen Eingang hat, der mit einem Ausgang des Schreib-Schieberegisters (6) mit einem ersten Streckenrang gekoppelt ist, wobei das zweite Register (15-2) einen Eingang hat, der mit einem zweiten Ausgang des Schreib-Schieberegisters (6) mit einem zweiten Streckenrang gekoppelt ist, der vom ersten Rang verschieden ist, wobei die Spalte (12), die mit dem ersten Ausgang des ersten Rangs gekoppelt ist, und die Spalten (12), die mit den Ausgängen gekoppelt sind, die auf einer Speicherstrecke zwischen dem ersten Validierungsausgang und dem zweiten Validierungsausgang liegen, gemeinsam einen ersten Teil des Matrixnetzes (10) bilden, wobei die Spalten (12), die mit dem zweiten Ausgang vom zweiten Rang gekoppelt sind, und die Spalten (12), die mit den Ausgängen gekoppelt sind, die auf der Speicherstrecke zwischen dem zweiten Ausgang vom zweiten Rang und dem ersten Ausgang vom ersten Rang liegen, gemeinsam einen zweiten Teil des Matrixnetzes (10) bilden, wobei jeder Ausgang des ersten Registers (15-1) mit einem digitalen Validierungseingang der Zellen (2) eines zweiten Zeilenteils gekoppelt sind, der zum zweiten Teil des Matrixnetzes (10) gehört, und wobei jeder der Ausgänge des zweiten Registers mit einem digitalen Validierungseingang der Zellen (2) eines ersten Zeilenteils gekoppelt ist, der zum ersten Teil des Matrixnetzes (10) gehört.

9. Analoger Abtaster nach einem der Ansprüche 7 oder 8, **dadurch gekennzeichnet, dass** jedes Validierungsregister (15-1, 15-2) einen Eingang hat, der mit einem Validierungswortgenerator gekoppelt werden kann.

10. Analoger Abtaster (1) zur Speicherung von analogen Daten nach einem der Ansprüche 6 bis 9, **dadurch gekennzeichnet, dass** jede Zelle (2) des Netzes eine Kapazität (22) mit zwei Anschlüssen umfasst, einem ersten (22a) und einem zweiten (22b), wobei der erste Anschluss (22a) mittels eines ersten steuerbaren Unterbrechers (21 a), der zu einer ersten Schaltereinrichtung (21) gehört, mit einer Unterteilung (5-1, 2-2, ..., 5L) des Busses (5) gekoppelt ist, wobei der zweite Anschluss (22b) mit einem Rück-Teil (5b) des Busses (5) mit konstantem Potential mittels eines zweiten steuerbaren Unterbrechers (21 b) gekoppelt ist, der zu der ersten Schaltereinrichtung (21) gehört, wobei eine Steuerung (23a, 23b) für jeden dieser Unterbrecher (21 a, 21 b) mit digitalen Eingängen jeder der Zellen (2) gekoppelt ist.

11. Analoger Abtaster (1) zur Speicherung von analogen Daten nach Anspruch 10, **dadurch gekennzeichnet, dass** der zweite Unterbrecher (21 b), der zu der ersten Schaltereinrichtung (21) bei jeder Zelle (2) gehört, mit seinem Steuereingang mit einem Elementarverzögerer oder einem Halb-Elementarverzögerer der Verzögerungsleitung (9) verbunden ist, die stromaufwärts eines Ausgangs eines Elementarverzögerers (92) oder Halb-Elementarverzögerers (93, 94) liegt, mit dem ein Steuereingang des ersten Unterbrechers (21 a) verbunden ist, der zu der ersten Schaltereinrichtung (21) gehört.

12. Analoger Abtaster (1) zur Speicherung von analogen Daten nach einem der Ansprüche 10 oder 11, **dadurch gekennzeichnet, dass** der erste Unterbrecher (21 a), der zu der ersten Schaltereinrichtung (21) gehört, durch zwei parallel angeschlossene Transistoren gebildet ist, einen NMOS-Transistor und einen PMOS-Transistor.

13. Analoger Abtaster (1) zur Speicherung nach Anspruch 1, **dadurch gekennzeichnet, dass** er zwei analoge Eingangsbusse umfasst, einen ersten, der dazu ausgelegt ist, mit einer Quelle des abzutastenden Signals mit einer ersten Polarität verbunden zu werden, und einen zweiten, der dazu ausgelegt ist, mit einem Polaritätsinverter verbunden zu werden, der das abzutastende Signal empfängt und ein abzutastendes Signal mit einer zur ersten inversen zweiten Polarität liefert, wobei die zwei analogen Eingangsbusse unterteilt sind, um Unterteilungen zu versorgen, wobei jede Unterteilung einer Zeile des Matrixnetzes entspricht, und wobei jede dieser Unterteilungen einen Begleitverstärker (14) trägt, wobei die Zeilen in Zeilenpaaren angeordnet sind, wobei jedes Zeilenpaar eine Zeile des Matrixnetzes mit ungeradem Rang und eine Zeile des Matrixnetzes mit geradem Rang umfasst, wobei die Zeilen eines Paars aufeinanderfolgende Ränge haben, wobei die Zellen jeder Zeile mit ungeradem Rang mit einer Unterteilung des Busses gekoppelt sind, die das Signal der ersten Polarität trägt, und die Zellen jeder Zeile mit geradem Rang mit einer Unterteilung des Busses gekoppelt sind, die das Signal der zweiten Polarität trägt.

14. Verfahren zum Erfassen von analogen Abtastwerten eines analogen Signals, das an einem analogen Bus vorhanden ist, in Zellen, die gemeinsam ein Matrixnetz von Zellen mit C Spalten (12) und L Zeilen (13) oder Zeilenpaaren bilden, wobei C und L ganze Zahlen bezeichnen, wobei jede Spalte durch eine Reihenfolge von Elementarverzögerern gebildet ist und einen Spalteneingang hat zum Empfangen eines Pulses mit einer ansteigenden Flanke und einer abfallenden Flanke, wobei der Puls von einem Schieberegister stammt, welches durch ein Taktsignal gesteuert wird, wobei:
- ein Anfangssignal der Abtastwerterfassung für eine Zelle an einem ersten digitalen Eingang der Zelle empfangen wird,
- und wobei ein Endsignal der Abtastwerterfassung an einem zweiten digitalen Eingang der Zelle empfangen wird,
**dadurch gekennzeichnet, dass**:
- die Anfangs- und Endsignale der Abtastwerterfassung durch die ansteigende oder abfallende Flanke des Pulses gebildet sind, wobei diese Flanken nacheinander von einem der Elementarverzögerer der Spalte an einem physisch einzigen digitalen Eingang empfangen werden, der nacheinander den ersten digitalen Anfangssteuereingang und den zweiten digitalen Endsteuereingang für die Abtastwerterfassung bildet, oder sie jeweils von Elementarverzögerern der Spalte an einem ersten digitalen Anfangssteuereingang und dann an einem zweiten digitalen Endsteuereingang für die Abtastwerterfassung empfangen werden,
- für wenigstens eine Verzögerungsleitung (9), die einer Spalte (12) zugeordnet ist, oder für eine weitere Verzögerungsleitung (91) ein Phasenvergleich durchgeführt wird zwischen einem Signal der Verzögerungsleitung (9, 91) und einem Referenzsignal, wobei das Resultat des Phasenvergleichs eine Ladungspumpe (32) steuert, deren Ausgang wiederum eine Regelspannung der Elementarverzögerer (92) steuert.

15. Verfahren zur Erfassung von analogen Abtastwerten nach Anspruch 14, **dadurch gekennzeichnet, dass** der Puls, der die ansteigende und die absteigende Flanke umfasst, welche die Anfangs- und Endsteuersignale für die Abtastwerterfassung bilden, derart von einer momentanen Zelle zu einer folgenden Zelle geleitet wird, dass die Dauer der Abtastwerterfassung für alle Zellen des Matrixnetzes gleich ist.

16. Verfahren zur Erfassung von analogen Abtastwerten nach einem der Ansprüche 14 oder 15, **dadurch gekennzeichnet, dass** man eine maximale Frequenz der Abtastwerterfassung durch einen ganzen Teiler m der Zahl der Zeilen oder Zeilenpaare L teilt, wobei diese Frequenz dem Fall entspricht, in dem aufeinanderfolgende Abtastwerte in Erfassungszellen erfasst werden, die zu ein und derselben Spalte gehören, jedoch auf aufeinanderfolgenden Zeilen oder Zeilenpaaren liegen,
a) wobei man die Abtastwerterfassung für eine Zelle einer ersten Zeile des Matrixnetzes autorisiert,
b) wobei man dann die Abtastwerterfassung in den (m-1) Zellen der Spalte invalidiert, die zu Zeilen gehören, welche nacheinander auf die erste Zeile folgen,
c) wobei man dann die Abtastwerterfassung für die m-te Zeile autorisiert, die der ersten Zeile folgt,
d) und wobei man in der gleichen Weise die Schritte a, b, und c für die m folgenden Zeilen erneut beginnt, bis man die letzte Zeile des Matrixnetzes erreicht,
e) wobei man in der gleichen Weise für jede der Spalten erneut beginnt, bis alle Zellen der autorisierten Zeilen Abtastwerte enthalten,
f) wobei man die Schritte a) bis e) ausgehend von einer zweiten Zeile des Matrixnetzes erneut beginnt, dann eventuell ausgehend von einer dritten Zeile und man erneut beginnt, bis man mit der (m-1)-ten Zeile beginnt, derart, dass nach diesem letzten Schritt alle Zellen des Matrixnetzes einen analogen Abtastwert enthalten.

17. Verfahren zur Erfassung von analogen Abtastwerten nach einem der Ansprüche 14 bis 16, **dadurch gekennzeichnet, dass** man beim Empfang des Endsignals für die Abtastwerterfassung für eine beliebige Zelle zunächst die Zelle von einer Potentialleitung mit konstantem Potential entkoppelt und anschließend die Zelle vom analogen Bus entkoppelt, der das abzutastende analoge Signal trägt.
